(19) **Europäisches Patentamt**
**European Patent Office**
**Office européen des brevets**

(11) **EP 4 730 650 A1**

(12) **EUROPEAN PATENT APPLICATION**

(43) Date of publication:
**22.04.2026 Bulletin 2026/17**

(51) International Patent Classification (IPC):
**H03F 3/183** (2006.01)   **H03F 3/217** (2006.01)
**H03F 3/45** (2006.01)

(21) Application number: **25209878.5**

(22) Date of filing: **20.10.2025**

(52) Cooperative Patent Classification (CPC):
**H03F 3/2173; H03F 3/183; H03F 3/45475;**
H03F 2200/03; H03F 2200/171; H03F 2200/264;
H03F 2200/351; H03F 2200/462

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **21.10.2024 US 202463709876 P**

(71) Applicant: **RGB Systems, Inc.**
**Anaheim, CA 92805 (US)**

(72) Inventors:
• MENDENHALL, Eric
Anaheim, CA (US)
• MYSZYNSKI, Martin
Anaheim, CA (US)

(74) Representative: **Secerna LLP**
**The Old Fire Station**
**18 Clifford Street**
**York YO1 9RD (GB)**

(54) **CLASS D AMPLIFIER WITH CURRENT MODE CONTROL**

(57) An audio amplifier that implements current mode control without the use of an explicit or separate current mode sensor is disclosed. The audio amplifier may include a pair of feedback loops that provide current from a node located before an inductor of an output filter and current from a node located after the inductor of the output filter to an integrator circuit. The integrator circuit may be formed from existing circuitry of the audio amplifier controller. Thus, current mode control can be implemented without a separate current mode sensor. Further, the audio amplifier can be implemented as a half bridge or as a full bridge design without increasing the number of operational amplifiers compared to the half bridge.

**EP 4 730 650 A1**

**Description**

INCORPORATION BY REFERENCE TO ANY PRIORITY APPLICATIONS

This application claims priority to U.S. Provisional Application No. 63/709,876, which was filed on October 21, 2024, and is hereby incorporated by reference herein for all purposes. Any and all applications for which a foreign or domestic priority claim is identified in the Application Data Sheet as filed with the present application are hereby incorporated by reference under 37 CFR 1.57.

FIELD OF THE DISCLOSURE

The present disclosure relates to audio amplifiers. More specifically, the present disclosure relates to a full bridge class D amplifier with current mode control.

BACKGROUND

Audio amplifiers are often used to amplify an audio signal before providing the audio amplifier to a speaker. One common type of amplifier used to implement an audio amplifier is a class D amplifier. A class D amplifier is a switching amplifier in which the transistors of the amplifier operate as electronic switches. Typically, the transistors switch back and forth between a pair of supply rails. Often, the class D amplifier is controlled using a voltage mode controller.

SUMMARY

The systems, methods and devices of this disclosure each have several innovative aspects, no single one of which is solely responsible for all of the desirable attributes disclosed herein. Details of one or more implementations of the subject matter described in this specification are set forth in the accompanying drawings and the description below.

In some aspects, the techniques described herein relate to an audio amplifier including: a power output stage including a first LC filter and a second LC filter, the first LC filter configured to receive a comparator output signal from a comparator corresponding to an audio output signal and the second LC filter configured to receive an inverted comparator output signal from the comparator; and a control stage including: a first feedback loop between a first node and a first summing node, the first node between the comparator and a first inductor of the first LC filter, wherein the first feedback loop is configured to provide a first current to an inverting input of an integrator at the first summing node; a second feedback loop between a second node and a second summing node, the second node between the first inductor and an output load resistor of the audio amplifier, wherein the second feedback loop is configured to provide a second current to a noninverting input of the integrator at the second summing node; a third feedback loop between a third node and the second summing node, the third node between the comparator and a second inductor of the second LC filter, wherein the third feedback loop is configured to provide a third current to the noninverting input of the integrator at the second summing node; and a fourth feedback loop between a fourth node and the first summing node, the fourth node between the second inductor and the output load resistor of the audio amplifier, wherein the fourth feedback loop is configured to provide a fourth current to the inverting input of the integrator at the first summing node, and wherein an integrator output of the integrator provides current mode control of the audio amplifier.

In some aspects, the techniques described herein relate to an audio amplifier, wherein the first node is between an output stage, E2, and the first inductor, and wherein a first power transistor receives an output of the comparator at a positive terminal of the output stage, E2.

In some aspects, the techniques described herein relate to an audio amplifier, wherein the integrator includes an operational amplifier configured to receive an input signal at the inverting input and an inverted input signal at the noninverting input.

In some aspects, the techniques described herein relate to an audio amplifier, wherein the comparator receives a triangle wave at a negative input to the comparator and an output of the integrator at a positive input to the comparator.

In some aspects, the techniques described herein relate to an audio amplifier, wherein the audio amplifier implements a full bridge operation using a single operational amplifier.

In some aspects, the techniques described herein relate to an audio amplifier, further including a fifth feedback loop between the second node and the first summing node, wherein the fifth feedback loop includes a first RC circuit.

In some aspects, the techniques described herein relate to an audio amplifier, further including a sixth feedback loop between the fourth node and the second summing node, wherein the sixth feedback loop includes a second RC circuit.

In some aspects, the techniques described herein relate to an audio amplifier, wherein the first RC circuit is configured to match the second RC circuit.

In some aspects, the techniques described herein relate to an audio amplifier, wherein a voltage at the second node includes a first output voltage and a voltage at the fourth node includes a second output voltage.

In some aspects, the techniques described herein relate to an audio amplifier, further including a first square wave clock input to the first summing node, wherein a negative input of the comparator is connected to ground, and wherein the combination of the first square wave clock and the grounded comparator enables elimination of a triangle generator.

In some aspects, the techniques described herein relate to an audio amplifier, further including a second square wave clock input to the second summing node, wherein the second square wave clock input receives an inverted square wave clock signal relative to a square wave clock signal received at the first square wave clock input.

In some aspects, the techniques described herein relate to an audio amplifier, wherein the integrator output of the integrator provides current mode control of the audio amplifier without inclusion of a current sensor.

In some aspects, the techniques described herein relate to an audio amplifier, wherein the integrator includes a differential integrator.

In some aspects, the techniques described herein relate to an audio amplifier, wherein the first feedback loop includes a first resistor configured to provide the first current to the inverting input of the integrator, wherein the second feedback loop includes a second resistor configured to provide the second current to the noninverting input of the integrator at the second summing node, and wherein the first resistor and the second resistor have the same resistance.

In some aspects, the techniques described herein relate to an audio amplifier, further including a synchronization square wave clock connected to a negative input of the comparator.

In some aspects, the techniques described herein relate to an audio system including: a speaker configured to output audio; and an audio amplifier in communication with the speaker and configured to provide an audio output signal to the speaker for output, wherein the audio amplifier includes: a power output stage including a first LC filter and a second LC filter, the first LC filter configured to receive a comparator output signal from a comparator corresponding to an audio output signal and the second LC filter configured to receive an inverted comparator output signal from the comparator; and a control stage including: a first feedback loop between a first node and a first summing node, the first node between the comparator and a first inductor of the first LC filter, wherein the first feedback loop is configured to provide a first current to an inverting input of an integrator at the first summing node; a second feedback loop between a second node and a second summing node, the second node between the first inductor and an output load resistor of the audio amplifier, wherein the second feedback loop is configured to provide a second current to a noninverting input of the integrator at the second summing node; a third feedback loop between a third node and the second summing node, the third node between the comparator and a second inductor of the second LC filter, wherein the third feedback loop is configured to provide a third current to the noninverting input of the integrator at the second summing node; and a fourth feedback loop between a fourth node and the first summing node, the fourth node between the second inductor and the output load resistor of the audio amplifier, wherein the fourth feedback loop is configured to provide a fourth current to the inverting input of the integrator at the first summing node, and wherein an integrator output of the integrator provides current mode control of the audio amplifier.

In some aspects, the techniques described herein relate to an audio system, wherein the audio amplifier implements a full bridge operation using a single operational amplifier.

In some aspects, the techniques described herein relate to an audio system, further including a triangle wave generator configured to supply a triangle wave signal at a negative input to the comparator and an output of the integrator at a positive input to the comparator.

In some aspects, the techniques described herein relate to an audio system, further including: a first square wave clock input to the first summing node, wherein a negative input of the comparator is connected to ground, and wherein the combination of the first square wave clock and the grounded comparator enables elimination of a triangle generator; and a second square wave clock input to the second summing node, wherein the second square wave clock input receives an inverted square wave clock signal relative to a square wave clock signal received at the first square wave clock input.

In some aspects, the techniques described herein relate to an audio system, further including a synchronization square wave clock connected to a negative input of the comparator.

BRIEF DESCRIPTION OF THE DRAWINGS

Throughout the drawings, reference numbers are re-used to indicate correspondence between referenced elements. The drawings are provided to illustrate certain aspects of the subject matter described herein and not to limit the scope thereof.

Figure 1A illustrates a graph of a frequency response of a class D amplifier implemented using voltage mode control.
Figure 1B illustrates a block diagram of a class D amplifier using current mode control.
Figure 2A illustrates a block diagram of an audio amplifier system in accordance with certain embodiments.
Figure 2B illustrates a block diagram of a current controlled audio amplifier without an explicit current sensor in accordance with certain embodiments.
Figure 2C illustrates an example circuit implementation corresponding to the block diagram of Figure 2B in accordance with certain embodiments.
Figure 2D illustrates a block diagram of a simplified current controlled audio amplifier without an explicit current sensor and with a reduced opamp circuit in accordance with certain embodiments.

Figure 2E illustrates an example circuit implementation corresponding to the block diagram of Figure 2D in accordance with certain embodiments.

Figure 3 illustrates a circuit diagram of an audio amplifier in accordance with certain embodiments.

Figure 4A illustrates a block diagram of an integrator and modulator of the current controlled audio amplifiers of Figures 2B and 2D in accordance with certain embodiments.

Figure 4B illustrates a block diagram adjusting the location of the triangle generator of Figure 4A in accordance with certain embodiments.

Figure 4C illustrates a block diagram of a simplified modulator of Figures 4A and 4B in accordance with certain embodiments.

Figure 4D illustrates a block diagram of a current controlled audio amplifier using a square wave generator in accordance with certain embodiments.

Figure 4E illustrates an example circuit implementation corresponding to the block diagram of Figure 4D in accordance with certain embodiments.

Figure 5A illustrates a block diagram a block diagram of a current controlled audio amplifier without an explicit current sensor and using a differential integrator in accordance with certain embodiments.

Figure 5B illustrates an example circuit implementation corresponding to the block diagram of Figure 5A in accordance with certain embodiments.

Figure 5C illustrates a block diagram of the current controlled audio amplifier of Figure 5A using a square wave generator in accordance with certain embodiments.

Figure 5D illustrates an example circuit implementation corresponding to the block diagram of Figure 5C in accordance with certain embodiments.

Figure 6 illustrates a simplified circuit diagram of an output stage of an example class D amplifier in accordance with certain embodiments.

Figure 7 illustrates the frequency response of a class D amplifier implemented using current mode control in accordance with certain embodiments.

Figure 8 illustrates an example of a full bridge implementation of the current controlled audio amplifier of Figure 5B in accordance with certain embodiments.

Figure 9 illustrates an example of a shared op amp implementation of the full bridge current controlled audio amplifier of Figure 8 in accordance with certain embodiments.

Figure 10 illustrates an example of the shared op amp implementation of the full bridge current controlled audio amplifier of Figure 9 using a square wave clock in accordance with certain embodiments.

Figure 11 illustrates an example of a variable frequency current controlled audio amplifier with optional clock synchronization in accordance with certain embodiments.

Figure 12 illustrates a circuit diagram of a reduced circuit audio amplifier in accordance with certain embodiments.

Figure 13 illustrates a circuit diagram of a reduced circuit audio amplifier of Figure 12 using a square wave clock in accordance with certain embodiments.

DETAILED DESCRIPTION

Introduction

Certain types of amplifiers (e.g., audio amplifiers) may be used to amplify an audio signal. An amplified audio signal output by the audio amplifier may be provided as input to a speaker, which may output audio. There are different types of amplifiers that may be used as an audio amplifier. One example of an amplifier that may be used as an audio amplifier is a class D amplifier. A class D amplifier can include transistors used to switch between different rail voltages and is typically not a linear gain device. The switches of the class D amplifier may be switched rapidly between the supply rails +Vrail and -Vrail. Advantageously, in certain implementations, the class D amplifier can be more efficient than a linear amplifier. The class D amplifier may be implemented using field-effect transistors (FETs), such as metal-oxide-semiconductor field-effect transistors (MOSFETs).

Generally, the control system of the class D amplifier operates in a voltage mode. In the voltage mode, a voltage may be applied to a second order LC filter. The filter resonance is damped by the load resistance, which can lead to a great deal of peaking under unloaded or lightly loaded conditions. A class D amplifier typically includes a low-pass output filter that filters frequencies above a particular frequency threshold (e.g., frequencies above an audible frequency level). The voltage control mode allows the filter resonance to shape the frequency response of the output filter.

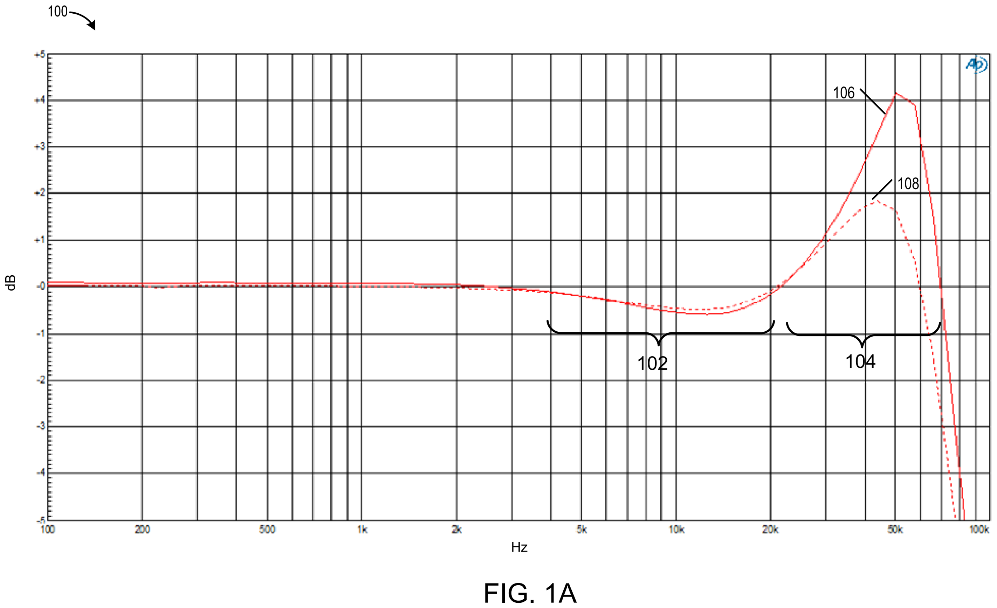

Figure 1A illustrates a graph 100 of a frequency response of a class D amplifier implemented using voltage mode control. The right side of the graph 100 illustrates how the resonance shapes the response of the output filter. From the graph 100, it can be seen that as the frequency of the output signal increases, the frequency response first dips or droops in the region 102 of the graph 100, and then peaks and begins to drop back down towards 0 dB in the region 104 of the graph 100.

The graph 100 illustrates two lines associated with different load conditions caused by the load on the audio amplifier by a speaker connected to the audio amplifier. The line 106 represents the frequency response of the class D amplifier without a load (e.g., when the audio amplifier is not connected to a speaker). The line 108 represents the frequency response of the amplifier when connected to a speaker with an 8 Ω impedance. It should be understood that different speakers may apply different load impedances to the audio amplifier resulting in different frequency responses. However, each of these frequency responses may include a droop in the region 102 and a peak in the region 104.

The region 102 with the droops is typically undesirable as it indicates a dip in the transfer function between the input and output signal. This dip in the transfer function can affect the accuracy of the reproduction of the audio (e.g., of music being output by a speaker connected to the amplifier). Ideally, it is desirable to have a flat frequency response so that the audio reproduction is accurate at all audible frequencies. In other words, it is usually desirable to have the same gain at high frequencies as is achieved at low frequencies.

The region 104 includes peaks that may exceed the pass band of the output filter of the amplifier. Further, the peaks may exceed the audio region. Thus, at least some of the peak may have a limited effect, or no effect, on the audio sound. However, the peaks can cause the output of the amplifier to exceed a threshold that can cause damage to a speaker.

One solution to keep the peaks reasonable, or from exceeding a threshold, is to add a damping network to prevent the gain at high frequencies from exceeding a threshold. Without the damping network, the gain may increase to dangerous levels at certain frequencies. For example, signal voltage may get high enough at certain frequencies (e.g., ultrasonic frequencies) to damage the speaker. For instance, assume a system is designed to output up to 100 volts. If the peak reached 6 dB, then the output may rise to 200 volts, which would exceed the component ratings and the design of the amplifier. The inclusion of the damping network can limit the peaks, but may add cost and introduce filter losses.

Another solution is to use high frequency switching for the class D amplifier. Figure 1A illustrates the use of high frequency switching to reduce peaks at certain higher output frequencies (e.g., at 50 kHz). Even with high frequency switching, as illustrated by the line 106, the peak may exceed 4 dB and, in some cases, the peak can reach up to 6 dB at higher frequencies. Accordingly, in the illustrated example, the output filter would need to accommodate up to twice the output voltage (e.g., 200 volts AC instead of 100 volts AC) to prevent damage to the speaker connected to the amplifier. The use of high-frequency switching, like the addition of a damping circuit, can also result in loss in the signal output. Further, as illustrated in Figure 1A, the use of high-frequency switching does not prevent the droops or dips, or fully prevent peaking.

Another solution is to use current mode control instead of voltage mode control. The use of current mode control can eliminate filter resonance, such as the filter resonance illustrated in Figure 1A, that can lead to the dips and peaks in the frequency response. The use of current mode control, in which a current loop is closed around the inductor current and feeds the output capacitor, can remove the peaking and allow a frequency response that more closely approximates a linear amplifier. To implement current mode control, it is necessary to sense the output current, or the current through the output filter. To sense the current, a current sensor may be inserted into the audio amplifier. There are several types of current sensors. For example, the current sensor can be a resistive sensor, a magnetic sensor, or a Hall effect sensor. However, each of these current sensors come with their own trade-offs or drawbacks.

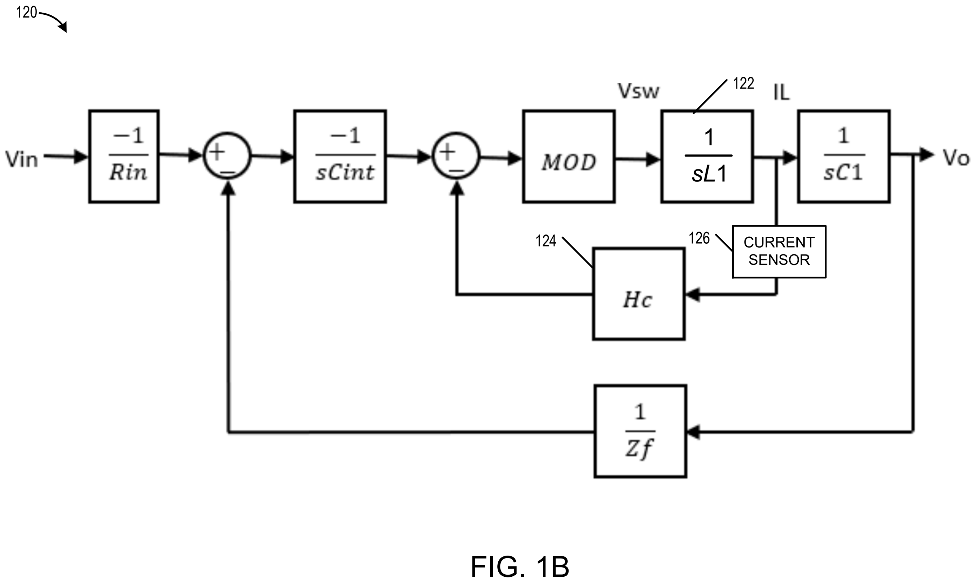

Figure 1B illustrates a block diagram of an example class D amplifier 120 using a current sensor to implement current mode control. The inductor current of the inductor 122 may be sensed directly, scaled and converted to a voltage by a transfer function represented by Hc 124. A current sensor 126 may be positioned between the inductor 122 and Hc 124 and may supply a sensed current to the transfer function Hc 124, which may then be fed back and subtracted from the current programming signal to form a current loop. The class D amplifier 120 may further include an outer voltage loop formed using a Type II system comprised of an impedance 1/Zf and an integrator 1/Cint. There are many ways to sense the inductor current. For example, the current sensor 126 may be a resistive current sensor or a current sense transformer.

Implementing a resistive current sensor may include adding a resistor in series with the output filter of the audio amplifier. The resistor is generally relatively small and provides a correspondingly very small signal that serves as the current sense signal. However, this small signal may be masked by or difficult to detect when compared to the relatively large voltage of the output filter. For example, the output voltage may reach 100 volts AC, while the current sense signal may be as small as 100 millivolts riding on top of the 100 voltage output signal. It can be difficult to detect the 100 millivolt current sense signal due, for example, to common mode errors associated with differential elements (e.g., an operational amplifier (op amp)) included in the amplifier. To sense the relatively small voltage (e.g., order of millivolts) of the current sense resistor riding on top of the relatively large voltage (e.g., order of volts) of the output filter, the voltage of the resistive current sensor must be translated down to ground level to be useable by the control circuit of the audio amplifier. However, translating the voltage level of the current sense resistor is impractical with commercially available resistors. To successfully adjust the voltage level, it would be necessary to trim the common mode voltage errors using, for example, a potentiometer. This is an impractical solution for an audio amplifier. Further, the resistive current sensor introduces some $I^2R$ loss into the amplifier. The smaller the signal, the worse the common mode errors become. Thus, the use of the current sense resistor to implement current mode control defeats the purpose of trying to eliminate the loss introduced using voltage mode control with the high frequency switching.

An alternative to using the current sense resistor is to use a magnetic sensor, or a current sense transformer. However, the current sense transformer is relatively large, expensive, and difficult to manufacture.

As another alternative, a Hall effect sensor can be used to sense current. However, a Hall effect sensor may introduce a lot of noise into the audio amplifier system. Further, the performance of the audio amplifier using a Hall effect sensor to implement current mode control is limited making it difficult if not impossible to obtain professional level performance for high-end applications.

Aspects of the present disclosure relate to an audio amplifier that implements current mode control without the use of an explicit or separate current mode sensor. The audio amplifier may include a pair of feedback loops that provide current from a node located before an inductor of an output filter and current from a node located after the inductor of the output filter to an integrator circuit. The integrator circuit may be formed from existing circuitry of the audio amplifier controller. Thus, current mode control can be implemented without a separate current mode sensor. Further, embodiments disclosed herein may simplify the amplifier by repurposing and repositioning integrators to reduce the number of integrators and to reduce the number of operational amplifiers used by the amplifier without increasing noise or total harmonic distortion in the audio amplifier.

Example Audio Amplifier System

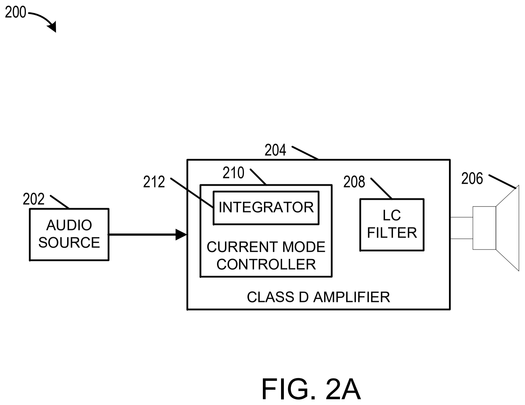

Figure 2A illustrates a block diagram of a sound system or an audio amplifier system 200 in accordance with certain embodiments. The audio amplifier system 200 may include an audio source 202 configured to supply an audio input signal to an amplifier, such as the audio amplifier 204. The audio source 202 may include any type of system that can generate an audio signal, or a pre-amp audio signal to be supplied to an audio amplifier. For example, the audio source 202 may be a television, a radio, a computing system, a disc player (e.g., Blu-ray player), or the like.

The audio source 202 may generate an audio signal. This audio signal may, in some cases, be directly provided to a speaker for output. However, in other cases, the audio signal is supplied to an amplifier, such as the audio amplifier 204. The audio amplifier 204 is a class D amplifier, and may include any type of Class D amplifier that can amplify an audio input signal before providing the amplified audio input signal to a speaker (or multiple speakers), such as the speaker 206. In some cases, the audio output signal of the audio amplifier 204 may be supplied to multiple speakers. In other cases, different audio output signals may be supplied to different speakers, such as in a stereo system or a surround sound system that can output different audio signals associated with one performance. The speaker 206 may be a single speaker or a set of multiple speakers. Further, the speaker 206 may represent a speaker system configured to output audio associated with different parts of a performance.

The audio amplifier 204 may include an output filter 208, such as an LC filter formed by one or more inductors and one or more capacitors. The output filter 208 may include any type of filter that can filter frequencies outside of the audio spectrum from an output signal of the audio amplifier 204. In some cases, the output filter 208 is a low pass filter configured to filter out or exclude frequencies within the output signal that exceed a particular frequency.

The audio amplifier 204 further includes a current mode controller 210. The current mode controller 210 may be any type of controller that can control the operation of the audio amplifier 204 based on a current of the audio amplifier 204 that is feedback from the output filter 208 to the current mode controller 210. Further, the current mode controller 210 may include an integrator 212 that is configured to integrate the feedback current. The current mode controller may be a type II controller. Additional details relating to the audio amplifier 204 and the current mode controller 210 are described herein.

Example Audio Amplifier Circuit

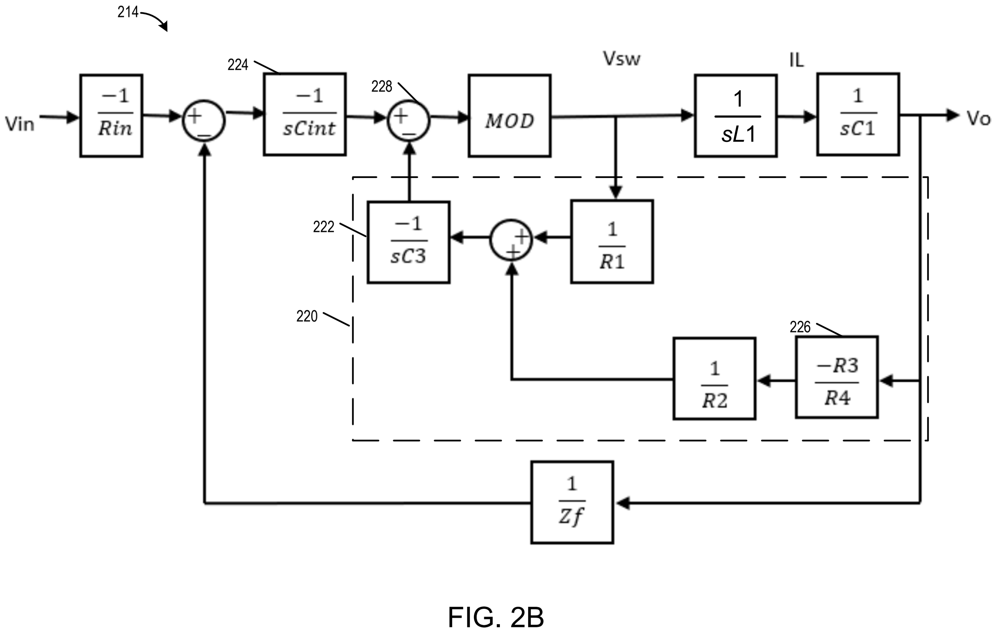

Figure 2B illustrates a block diagram 214 of a current controlled audio amplifier 204 without an explicit current sensor in accordance with certain embodiments. The current sensor 126 of the amplifier 120 may be replaced by an opamp circuit 220 that may sense the current of the audio amplifier 204. The opamp circuit 220 may be or may be part of the current mode controller 210. The opamp circuit 220 may include an integrator 222 represented by -1/sC3, which may be summed with another integrator 224 represented by - 1/sCint of the audio amplifier 204. The integrators may be summed by the adder circuit 228. Further, the opamp circuit 220 may include a pair of opamps with one being represented by the integrator 222 and one being represented by block 226 corresponding to -R3/R4.

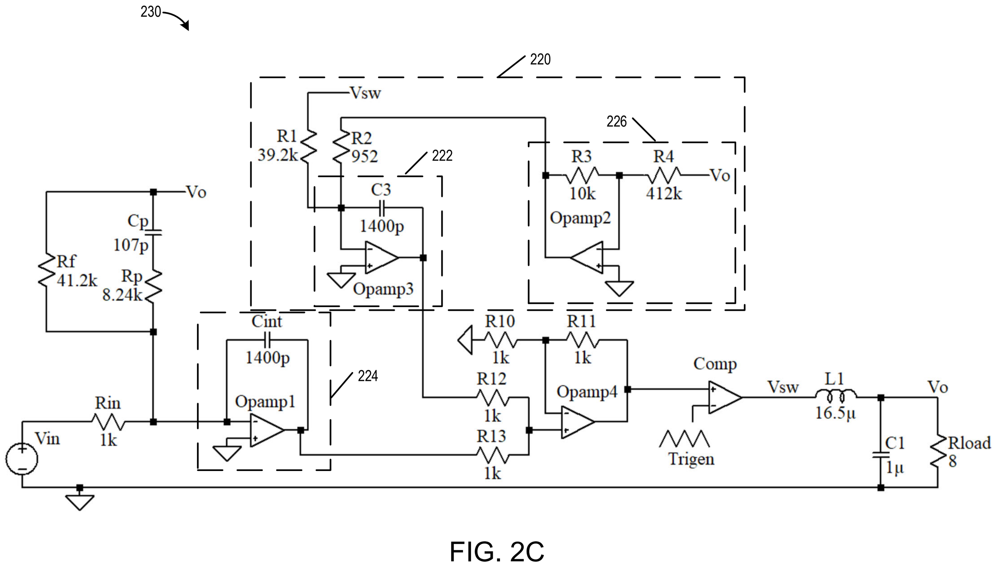

Figure 2C illustrates an example circuit 230 that corresponds to the block diagram of Figure 2B. As illustrated in Figure 2C, the opamp circuit 220 may be implemented using a pair of opamps, Opamp2 and Opamp3, with associated components R1, R2, R3, R4 and C3. Opamp2 may be included in the -R3/R4 block 226. Opamp3 along with C3 may function as the integrator 222.

The integrator 222 receives currents as inputs. Thus, to sense the current of the inductor L1, we need a total current input proportional to the voltage across the inductor L1. This voltage in the circuit 230 may be given by (Vsw/Vo). A first current, Vsw/R1, may be supplied to the integrator 222 directly through the resistor R1. For the second term a current equal to -Vo/R1 is needed. To get the negative sign an inverting opamp (Opamp2) may be used. If the gain of the Opamp2 were -1, R2 could be set equal to R1. However, since the output amplitude is usually much higher than the opamp supports, R3/R4 may be selected as the inverse of the power amplifier overall gain, scaling Vo back down to Vin. Scaling the voltage down means the resistor R2 must also be scaled

down such that:

$$R2 = R1 * \frac{R3}{R4} \qquad (1)$$

For the case where C3 = Cint, the opamp circuit 220 can be simplified to remove an integrator. In Figures 2B and 2C, the output of two integrators are being subtracted. In other words, the output of the integrator 222 is being subtracted from the output of integrator 224. Since the integral of a sum is the sum of the integrals, it is possible to eliminate an integrator by modifying the location of the integrator relative to the summing or adder circuit.

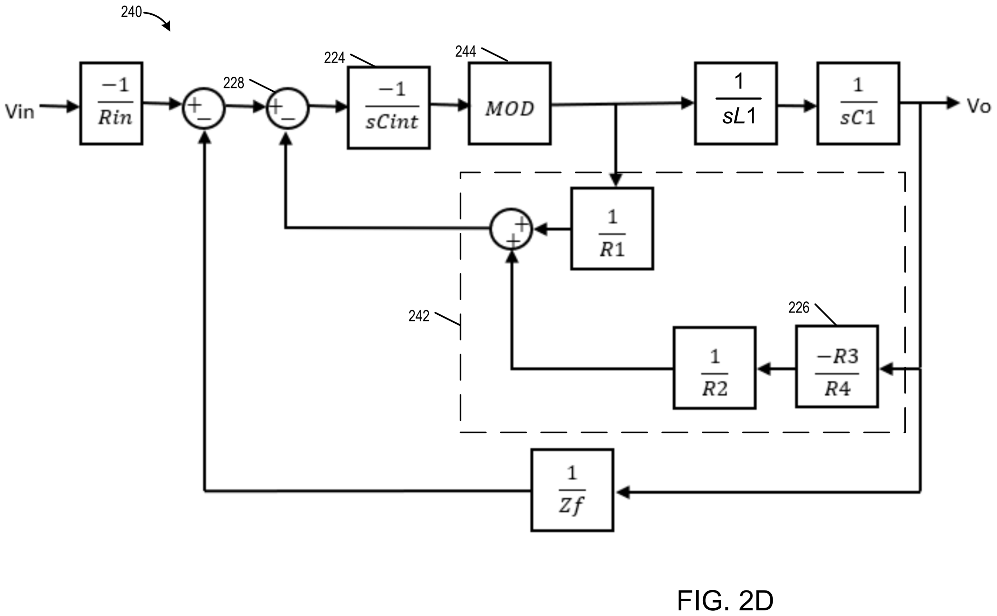

Figure 2D illustrates a block diagram 240 of a simplified current controlled audio amplifier without an explicit current sensor and with a reduced opamp circuit in accordance with certain embodiments. Comparing the block diagram 240 to the block diagram 214 of Figure 2B, it can be determined that the integrator 224 is moved from before the adder circuit 228 to after the adder circuit 228, and, in the case where C3 = Cint, the integrator 222 may be eliminated. The adder circuit 228 may comprise any type of circuit that can add two signals. In some cases, the adder circuit 228 may be a node within the circuit that serves to sum two received signals. This node may also be referred to as a summing node.

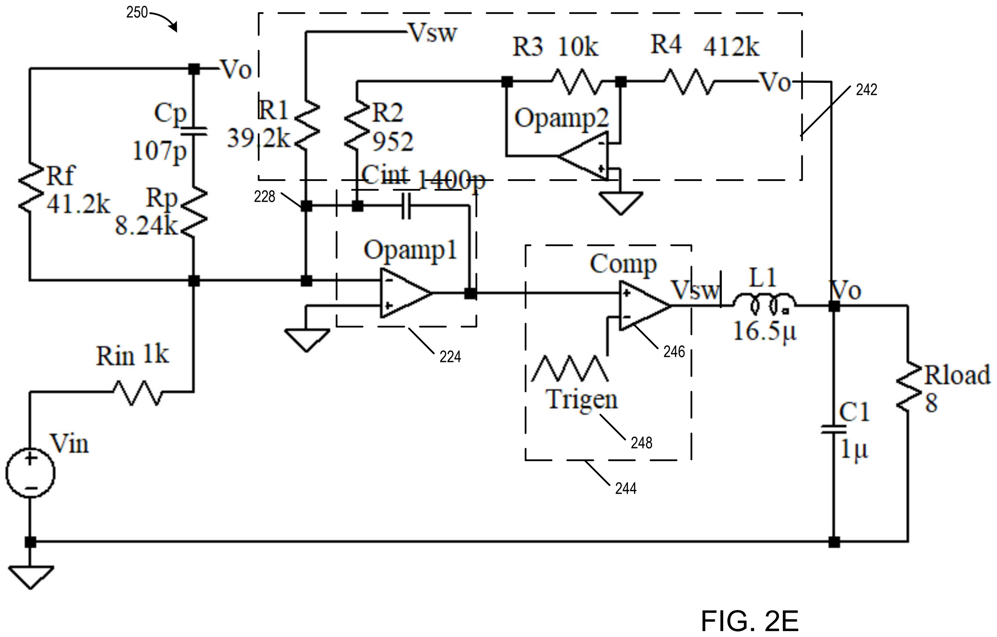

Further, as illustrated by the audio amplifier circuit 250 of Figure 2E, the removal of the integrator enables the reduction of opamps from two in the opamp circuit 220 to one in the opamp circuit 242. Moreover, as illustrated in Figure 2E, because the extra integrator has been eliminated, it is possible to remove a second opamp corresponding to Opamp4 in Figure 2C previously used to sum the integrators 222 and 224. Consequently, the number of opamps in the audio amplifier may be reduced from 4 opamps in the circuit 230 to 2 opamps in the circuit 250. Advantageously, the reduction in opamps results in reduced circuit complexity and cost compared to prior designs.

To simplify the figures, and not to limit the disclosure herein, a number of feedback loops included in the circuits described herein are not fully illustrated within the figures. These loops are instead indicated in the drawings by duplicating labels to indicate that a circuit path exists between two points. For example, in Figure 2E, the labels Vsw after the comparator 246 and the label Vsw before the resistor R1 indicates that a circuit path exists connecting the two points labelled Vsw. Thus, the switching voltage Vsw is fed back from the comparator 246 to the input of the integrator 224 via the loop between the comparator 246 and the resistor R1. Similarly, the output voltage Vo is feedback to the RC circuit formed from the resistor Rp and the capacitor Cp as labelled in Figure 2E. Other feedback loops exist in the various circuits illustrated herein as identified by different nodes within the circuits that share common labels.

## Second Example Audio Amplifier Circuit

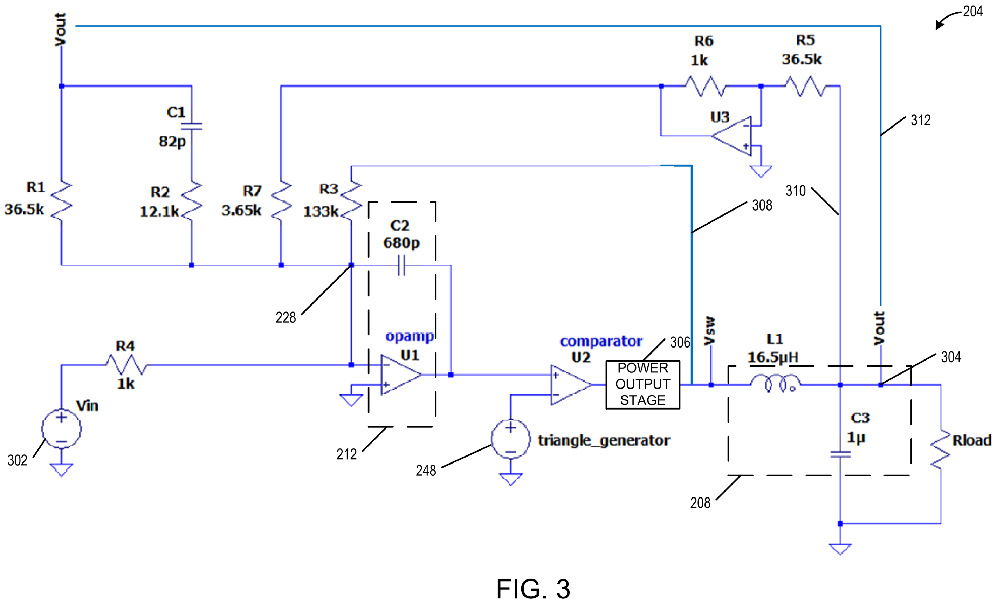

Figure 3 illustrates a circuit diagram of an audio amplifier 204 in accordance with certain embodiments. The circuit of Figure 3 is similar to the circuit of Figure 2E, but illustrates the use of different circuit values. It should be understood that different resistance, capacitor, and inductance values may be used in the audio amplifier 204 based on the desired specifications for the audio amplifier 204. Moreover, the embodiments described above with respect to Figures 2A-2E are applicable to Figure 3 and vice versa.

The audio amplifier 204 may receive an input audio signal, represented by $V_{in}$ 302, and generate an amplified version of the audio signal that is output to a speaker at $V_{out}$ 304 that is connected or in communication with the audio amplifier 204. The speaker may be represented by the load $R_{load}$. The output signal $V_{out}$ may be processed or filtered by an output filter 208. The output filter 208 may be an LC filter implemented by the inductor L1 and the capacitor C3. In some cases, the output filter 208 may be an RLC circuit. Further, the output filter 208 may receive an output signal from the power output stage 306 and filter out the frequencies above a particular threshold while maintaining frequencies below the threshold. The frequency threshold may be selected to correspond to an upper limit of frequencies that can be heard by at least certain users or humans. In some cases, the threshold may be higher than the human audible spectrum. For example, the threshold may be set at 20 kHz, 30 KHz, 50 kHz, or higher or any range between the preceding.

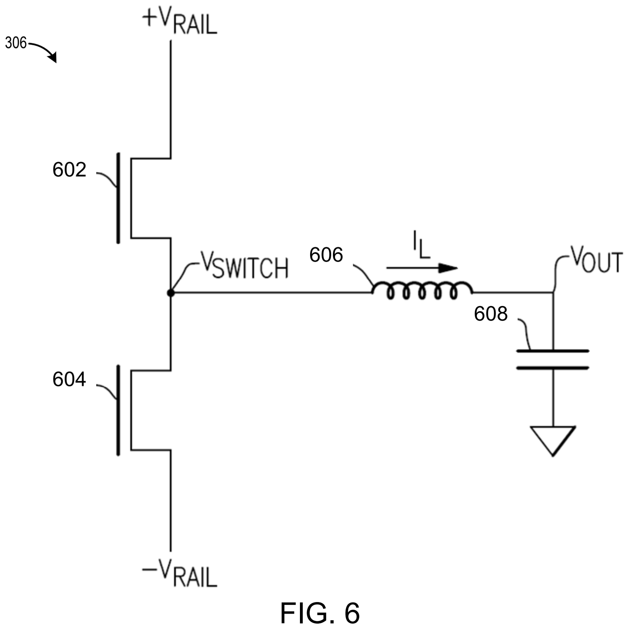

The power output stage 306 may be one stage of a multi-stage amplifier. The power output stage 306 may include a pair of transistors connected between two rail voltages. The power output stage 306 may switch between the two rail voltages. Often, but not necessarily, the two rail voltages are of the same magnitude, but opposite phase (e.g., +/-5 Volts). Additional details of an example power output stage 306 are illustrated in Figure 6 below.

The audio amplifier 204 may include a type II controller that is formed by an op amp U1, resistors R1, R2, R4, and capacitors C1 and C2. The type II controller may control the switching frequency of the audio amplifier 204. Controlling the switching frequency of the audio amplifier 204 may include controlling the switching frequency of switching connecting transistors of the power output stage 306 between at least a first rail voltage and a second rail voltage.

To enable the current mode control, it is desirable to determine the current flowing through the inductor L1 of the output filter 208. The inductor current and voltage are related by the equation $V = L \, di/dt$, or $I = 1/L \int V dt$. Thus, determining the integral of the voltage across the inductor L1 divided by the inductance L of the inductor L1 may provide the current through the inductor L1. The integration may be performed by an integrator 212 formed using the op amp U1 and the capacitor C2 of the controller of the audio amplifier 204. The op amp U1 and the capacitor C2 are included as part of the audio amplifier controller, which may be a type II (or type 2) controller. In the absence of the current mode control, U1 and C2 along with additional components may be used to a form a Type III control system. Thus, in the present disclosure, U1 and C2 may be repurposed to determine the current through the inductor L1 without the addition of a separate integrator. The integrator may be used for current mode control as part of the type II controller, and also may be used to reconstruct inductor current by integrating the inductor voltage. Thus, current mode control can be performed by supplying a current through the inductor L1 into the summing node 228 that is proportional to the winding voltage of the inductor L1. This current may be described as (Vsw-Vout)/R3, where Vsw represents the switching voltage before the inductor L1, and Vout represents the output voltage after the inductor L1.

The inductor current may be provided to the summing node 228 by dividing the current described by the equation (Vsw-Vout)/R3 into two parts. The first current, Vsw/R3 may be supplied by a first feedback loop 308. The first feedback loop 308 may include the resistor R3 that is configured to supply the current Vsw/R3 to the summing node 228. A second feedback loop 310 may be used to provide the current -Vout/R3 to the summing node 228. Thus, the inductor current is sensed or determined by sensing the voltage on each side of the inductor L1. As we can determine the voltage on each side of L1, we can integrate the voltage to determine the current. The second feedback loop 310 may be formed from the resistors R5, R6, and R7 connected in series, and an op amp U3. The resistor R6 may further be connected between the inverting input of the op amp U3 and the output of the op amp U3. The op amp U3 inverts the voltage value through the feedback lip 310 enabling the current Vout/R3 to be subtracted from the current Vsw/R3 to obtain the current through the inductor L1. As illustrated in Figure 3, current may also flow through R1 and R2 into the summing node as part of the Type II controller functionality, but is not included in the inductor current reconstruction addressed by the above equations.

Figure 3 illustrates example values for the resistors R3, R5, R6, and R7 used in the first feedback loop 308 and the second feedback loop 310. It should be understood that the illustrated values are examples and other resistors may be used. However, although other resistors are possible, the resistors may be subject to the constraint R7 = R3*R6/R5. In other words, the resistance of R7 may be equal to the resistance of R3 multiplied by a ratio of the resistance of R6 to the resistance of R5.

The output of the integrator 212 may be supplied to a first input of the comparator U2, which can compare the integrator 212 output to a signal generated by the triangle generator and supplied to a second input of the comparator U2. The output of the comparator U2 may be supplied to the power output stage 306 of the audio amplifier 204 to control operation of the power output stage 306. Based on the control signal supplied to the power output stage 306, the transistors of the power output stage 306 may connect to or receive a voltage from one of at least a pair of rail voltages. The integrator output and the triangle wave from the triangle generator may be provided to the comparator U2. The comparator U2 output may drive the power output stage 306. Generally, the comparator U2 has a relatively small signal level (e.g., +2.5 V to -2.5 V). The power output stage 306 may convert the signal to a larger signal level (e.g., +100 V to -100 V, or +80 V to -80 V). Although not illustrated in all of the example circuits illustrated herein, it should be understood that a power output stage 306 may exist between the comparator and the output filter as illustrated in Figure 3.

Advantageously, in certain embodiments, the loss is reduced or eliminated using the current mode control illustrated in Figure 3. Further, by reusing the existing integrator 212 and adding a feedback loop 310, the circuit size and complexity is reduced compared to using a separate current sensor or voltage mode control.

Example Square Wave Audio Amplifier Circuit

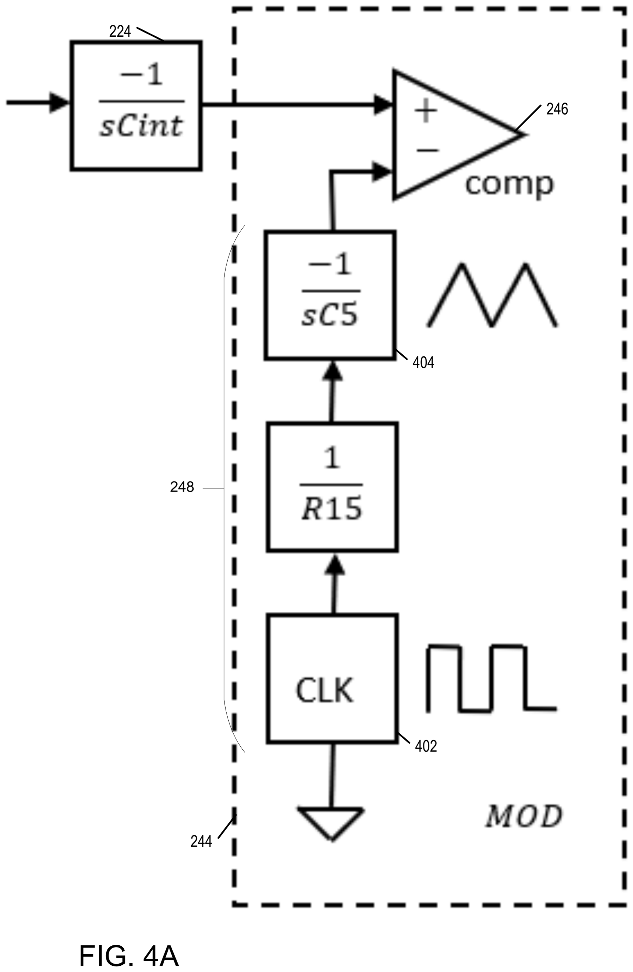

The audio amplifier circuits illustrated in Figures 2A-2E and Figure 3 are implemented using a triangle generator (e.g., the triangle generator 248). To further simplify the audio amplifier, the triangle generator 248 may be combined with the integrator 224. Referring to Figure 2D, the integrator 224 and the modulator 244 can be expanded as illustrated in Figure 4A. The modulator 244 may include the comparator 246 and the triangle generator 248 illustrated in, for example, Figure 2E.

Referring to Figure 4A, the triangle signal generated by the triangle generator 248 may be generated from a square wave clock 402 using an integrator circuit 404. By making similar adjustments to the modulator 244 that were made to the opamp circuit 220, it is possible to eliminate the integrator circuit 404 further simplifying the audio amplifier 204.

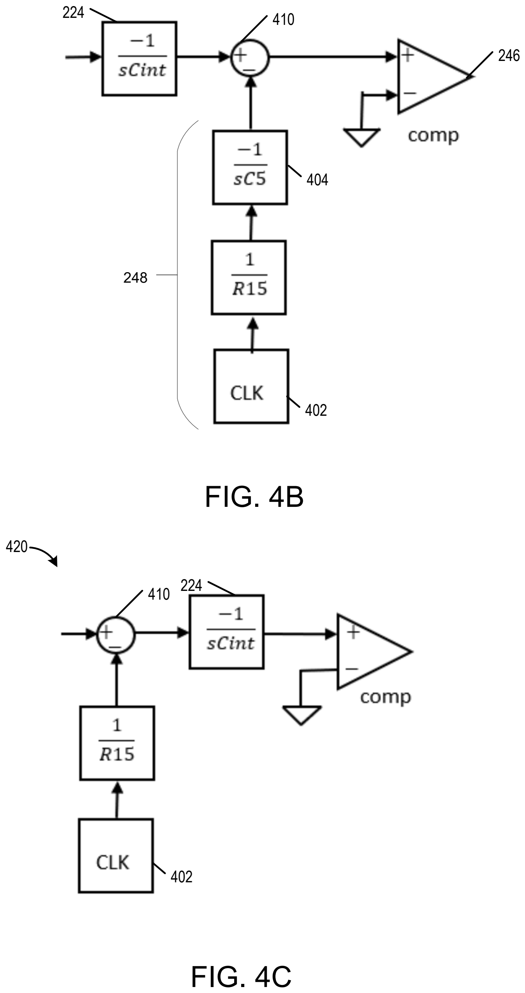

Referring to Figure 4B, the first step in eliminating the integrator circuit 404 is to shift the triangle generator 248 from the inverting input of the comparator 246 to the noninverting input of the comparator 246 by adding the signal of the triangle generator 248 to the output of the integrator 224 using an adder or summer circuit 410. It is possible to move the triangle generator 248 from one input of the comparator 246 to the other input of the comparator 246 by subtracting the signal from each side. Subtracting the triangle generator 248 from the inverting input of the comparator 246 puts the inverting input to ground. The summer circuit 410 may then be used to subtract the triangle generator 248 from the integrator 224.

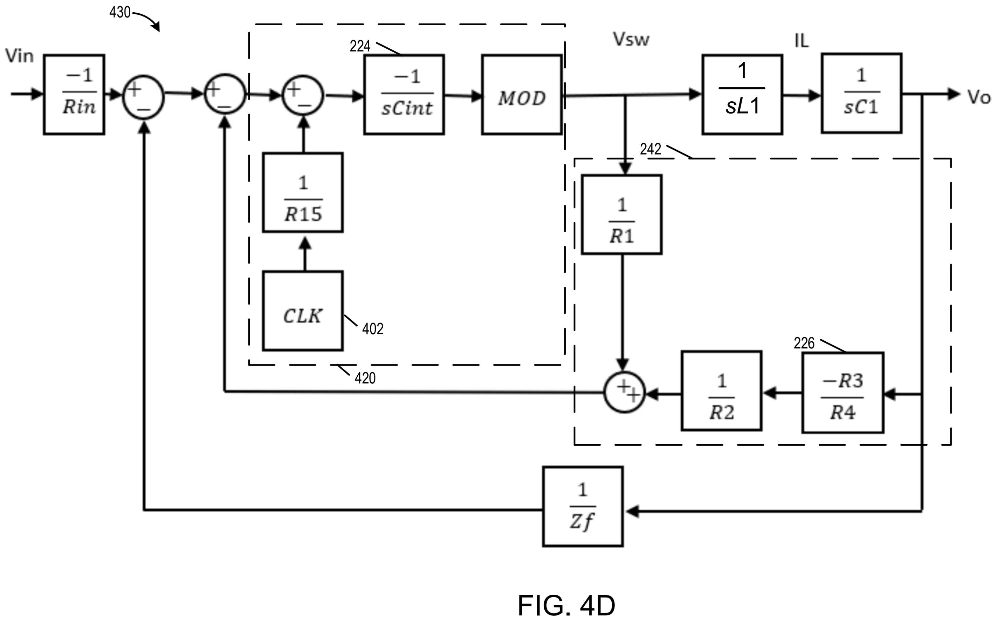

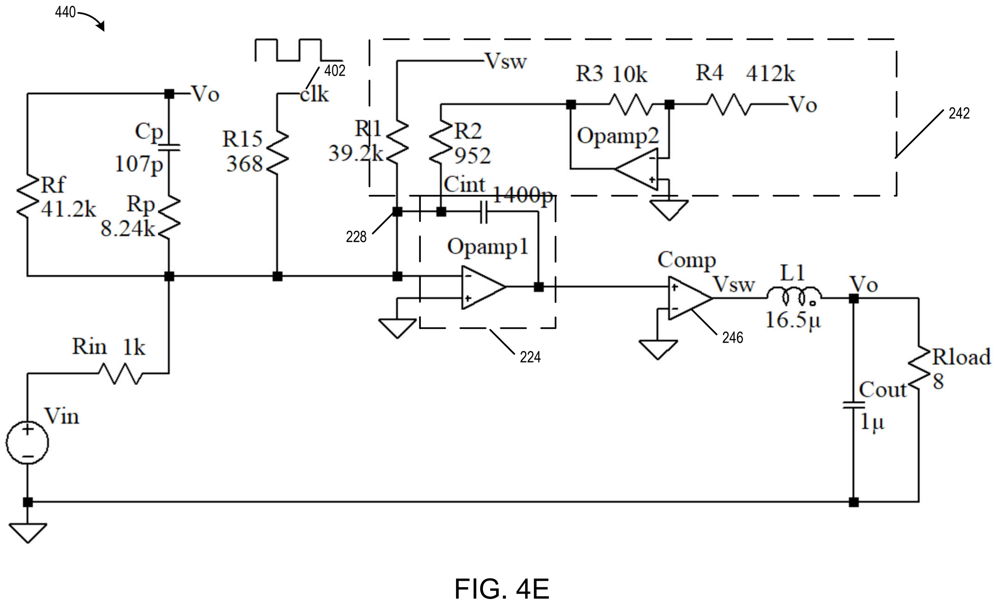

As previously explained, as the sum of integrals can be equated to the integral of the sum, it is possible to eliminate one of the integrators by repositioning it with respect to the summer circuit 410. Thus, as illustrated in Figure 4C, moving the integrator 224 to the output of the summer circuit 410 enables elimination of the integrator 404 (or combining of the integrator 404 with the integrator 224) from the triangle generator 248. Moreover, replacing the combination of the integrator 224 and modulator 244 with the circuit 420 illustrated in Figure 4C enables the audio amplifier 204 to operate directly from a square wave eliminating the need for using a triangle wave. The use of the square wave clock 402 in place of a triangle wave for the audio amplifier 204 is illustrated in Figures 4D and 4E.

Comparing the block diagram 240 of Figure 2D with the block diagram 430 of Figure 4D, an audio amplifier 204 configured to use a triangle wave can be converted to using a square wave clock by replacing the integrator 224 and modulator 244 with the circuit 420. The resultant audio amplifier circuit that uses a square wave clock directly in place of the triangle wave may be depicted by the audio amplifier circuit 440 of Figure 4E. Comparing the circuit 440 of Figure 4E to the circuit 250 of Figure 2E, the triangle generator 248 may be omitted and the circuit 250 may operate directly based on the square wave clock 402. As illustrated with Figures 4A-4C, the triangle generator may also include the square wave clock 402. However, by directly using the square wave clock 402 in place of the triangle generator 248, the number of integrators may be reduced.

It should be understood that there are advantages to using both the audio amplifier 250 with the triangle generator 248 and the audio amplifier 440 without the triangle generator. In some cases, noise and total harmonic distortion may be reduced using either the audio amplifier 250 or the audio amplifier 440, and the selection of audio amplifier design may depend on the application for the audio amplifier and the frequencies supported.

As previously indicated, using the opamp based circuit enables current control without the use of an explicit current sensor. Further, the number of opamps required can be reduced using the circuit simplifications disclosed herein. However, as disclosed in the next section, it is also possible to design an audio amplifier without using the opamp feedback method (which may also be referred to as an inverter method) disclosed above enabling further reduction in the opamps used by the audio amplifier. The inverter method can maintain zero volts at the inputs to the opamps. The differential integrator method discussed in the next section may further reduce the number of opamps, but may not maintain zero volts at the inputs to the opamps it does include. In some cases, it may be desirable to be able to maintain zero volts at the inputs to the opamps to enable the amplifier circuit to work with other circuits, such as a clip limiter circuit, included in a system. Thus, although the differential integrator version of the amplifier circuit may be desirable in some cases to reduce circuit complexity and size, in other cases the inverter version of the amplifier circuit may be desirable to enable the amplifier to work with other circuits included in a system.

Example Differential Integrator Audio Amplifier

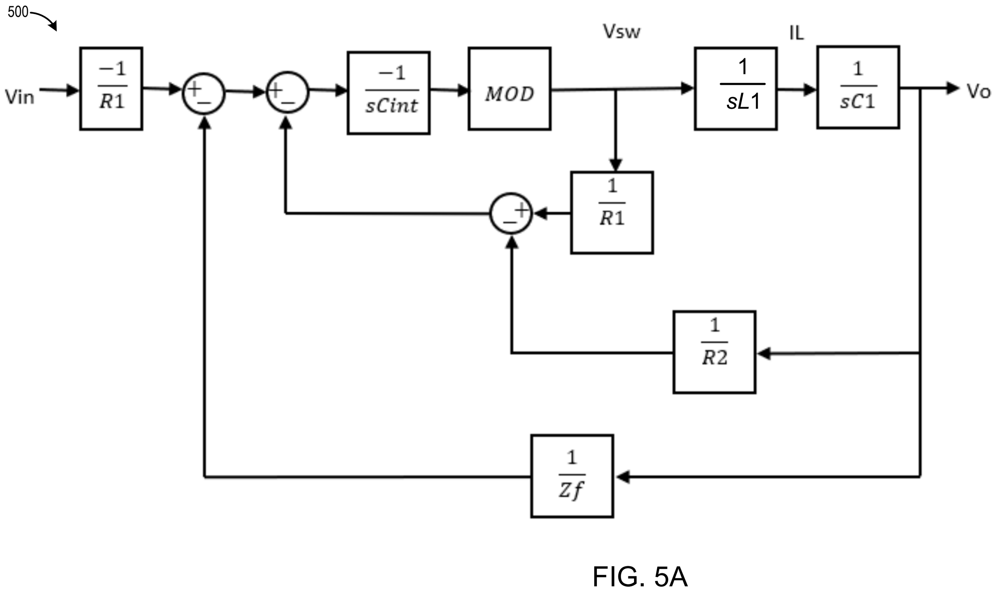

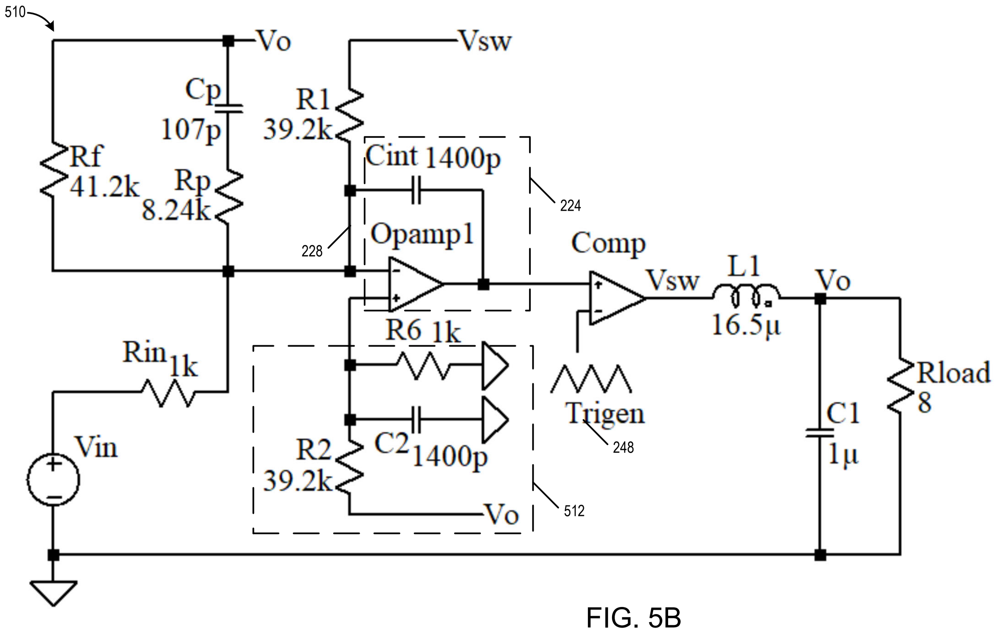

As an alternative to the opamp feedback method disclosed with respect to Figures 2B-2E and Figures 4D and 4E, the feedback can be taken into the positive input of a differential integrator as shown in Figure 5B. Advantageously, as illustrated by the block diagram 500 of Figure 5A, by providing the feedback of Vo to the positive input of the integrator 224, the integrator 226 represented by -R3/R4 can be eliminated.

Figure 5B illustrates the modification to the feedback loop in the circuit 510 using the differential integrator method compared to the circuit 250 using the inverter method includes replacing the ground connection to the Opamp 1 with a feedback loop 512 comprising an RC circuit that feeds back the audio amplifier output signal Vo to the positive input of the Opamp1. This RC circuit may be coupled to the positive input of the operational amplifier included as part of the integrator 224. Moreover, the opamp circuit 242, including the integrator 226 may be eliminated. Thus, the number of opamps utilized by the audio amplifier may be further reduced compared to the audio amplifier circuit 230 from four opamps to one opamp.

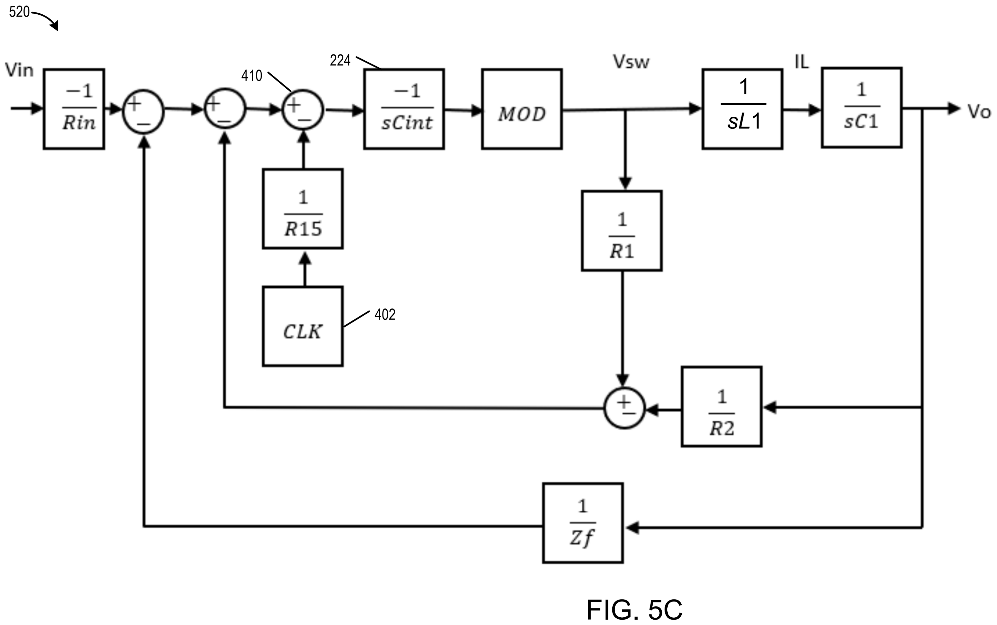

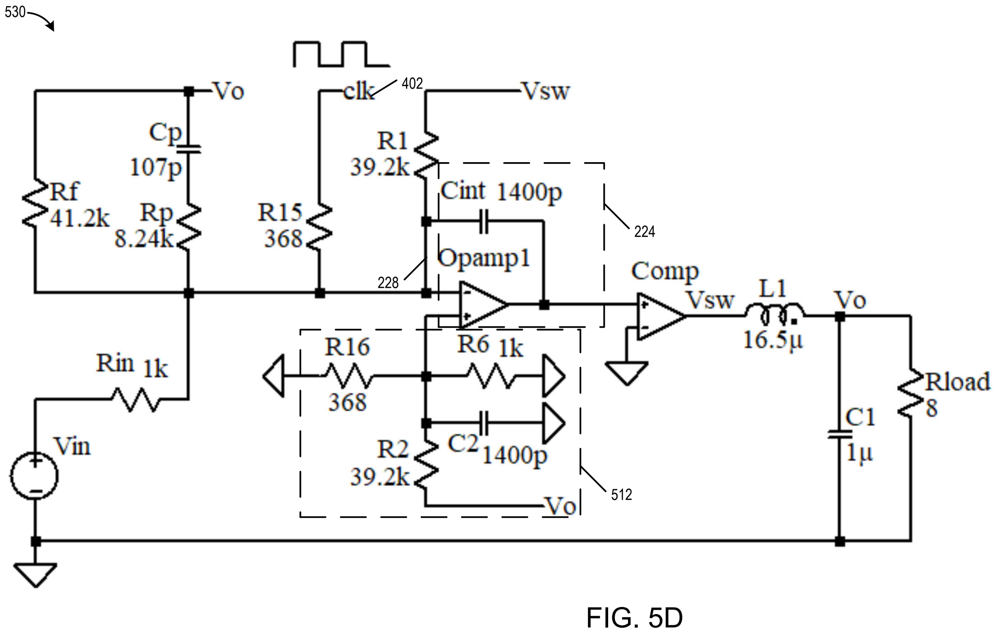

Further, just as the audio amplifier circuit 250 can be modified to remove the triangle generator 248 and function using the square wave clock 402 as illustrated in Figure 4E, so can the audio amplifier 510 be modified to remove the use of the triangle generator 248. Eliminating the triangle generator 248 enables the elimination of an integrator further simplifying the audio amplifier circuit enabling reduced noise and smaller form factors for the audio amplifier. Figures 5C and 5D, reflect the conversion of the audio amplifier 510 from using a triangle generator 248 to operating directly using a square wave clock 402. Figure 5C presents a block diagram 520 illustrating the clock signal of a square wave clock 402 being supplied to the integrator 224 via the adder 410. Figure 5D presents an audio amplifier circuit 530 that is an example implementation of the block diagram 520 of Figure 5C. As illustrated by the audio amplifier circuit 530, a square wave clock 402 may be fed to the integrator 224. Further, as explained with respect to Figures 4A-4C, the reconfiguration of the circuit to support using the square wave clock 402 in place of the triangle generator 248 can eliminate an additional integrator 404 simplifying the audio amplifier circuit.

Example Amplifier Output Stage

Figure 6 illustrates a simplified circuit diagram of an output stage 306 of an example class D amplifier in accordance with certain embodiments. The output stage 306 is one non-limiting example of an output stage that can be used with the audio amplifier 204.

The illustrated portion of the class D amplifier in Figure 6 illustrates an output stage 306 implemented by a pair of transistors and an output LC filter. The output LC filter of the output stage 306 may be formed, for example, by L1 and C3 of Figure 3, L1 and C1 of Figure 5D, or any other LC filter stage illustrated at the output of the audio amplifiers circuits described herein. A number of additional elements may form part of the class D amplifier as illustrated in Figure 3. The output stage 306 may include a pair of switches 602 and 604 implemented by transistors. These transistors 602, 604 may be field-effect transistors (FETs), such as metal-oxide-semiconductor FETs (MOSFETs). The switch 602 may be connected to +Vrail and the switch 604 may be connected to -Vrail. Further, the switches 602 and 604 may alternate between on and off states with one switch being on while the other switch is off. Thus, when the switches are active, the output or switch voltage Vswitch, may alternate between +Vrail and -Vrail.

It should be understood that Figure 6 illustrates one non-limiting example of the output stage of a class D amplifier. Other implementations are possible.

Further, as previously described, the amplifier may include a filter, such as an LC filter that includes an inductor 606 (or inductor L1 of Figure 3) and a capacitor 608 (or capacitor C3 of Figure 3). When the output stage 306 is active, a current may flow through the inductor 606 charging the inductor 606 and, in some cases, the capacitor 608. An output signal may appear at the node Vout, which can be provided to a subsequent system, such as a speaker system.

Experimental Results

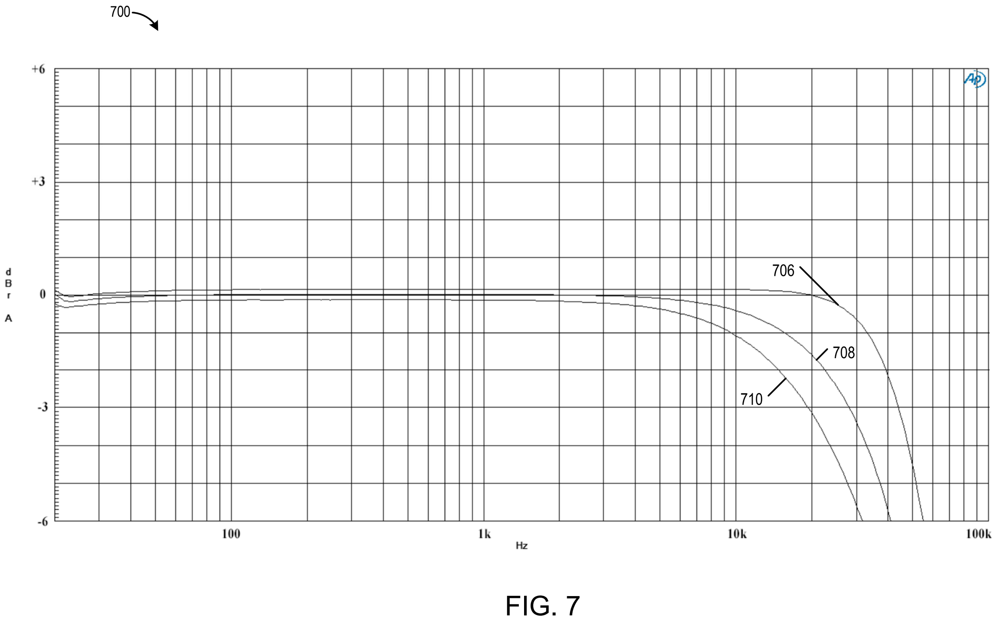

Figure 7 illustrates the frequency response of the example audio amplifier circuits implemented using the current mode control described herein. The graph 700 illustrated in Figure 7 illustrates experimental results for a frequency response of three load conditions of implementations of the inverter triangle wave audio amplifier circuit 250 of Figure 2E, the inverter square wave audio amplifier circuit 440 of Figure 4E, the differential integrator triangle wave audio amplifier circuit 510 of Figure 5B, and the differential integrator square wave audio amplifier circuit 530 of Figure 5D. As all four circuit implementations performed similarly with respect to noise levels, total harmonic distortion (THD), and frequency response, each of the three lines in the graph 700 cumulatively represent the four circuits 250, 440, 510, and 530 under different load conditions.

The graph 700 illustrates three lines associated with different load conditions caused by the load on the audio amplifier circuits by a speaker 206 connected to or in communication with the audio amplifier circuits 250, 440, 510, or 530. The line 706 (corresponding to the line 106 of Figure 1A) represents the frequency response of the audio amplifier without a load (e.g., when the audio amplifier is not connected to a speaker). The line 708 (corresponding to the line 108 of Figure 1A) represents the frequency response of the amplifier when connected to a speaker with an 8 Ω impedance. The line 710 represents the frequency response of the amplifier when connected to a 4 Ω impedance. As can be seen in Figure 7, when using the current mode control of the present disclosure, the droops that were previously depicted in the region 102 of Figure 1A, and the peaks that were previously depicted in the region 104 of Figure 1A are eliminated. Instead, as illustrated in Figure 7, the frequency response of the audio amplifier rolls off at about 10 kHz depending on the load condition.

A number of different current mode control implementations of an audio amplifier without an explicit current sensor have been described herein. Further, as has been shown by the experimental results, each of the implementations may have similar noise, THD, and frequency response. Accordingly, each of the implementations described herein may be desirable under various conditions. Moreover, embodiments disclosed herein with respect to one audio amplifier design may be applicable to one or more other audio amplifier designs described herein. Advantageously, the audio amplifiers disclosed herein are simplified compared to existing audio amplifiers reducing both the number of opamps and the number of integrators used by the audio amplifier. This reduction in opamps and integrators not only simplifies circuit design, but it enables the audio amplifier to fit within a smaller form factor compared to existing audio amplifier designs.

Example Full Bridge Audio Amplifier

Embodiments of the audio amplifier described herein are described with respect to a half-bridge implementation. For example, the audio amplifier 510 illustrated in Figure 5B illustrates an example of a half-bridge implementations of a fixed frequency current model control amplifier. However, certain embodiments are also applicable to a full bridge audio amplifier. For example, using two of the audio amplifier 510, a full bridge implementation of the fixed frequency current model control amplifier can be implemented. Advantageously, having a full-bridge implementation can provide twice the voltage swing compared to a half-bridge implementation.

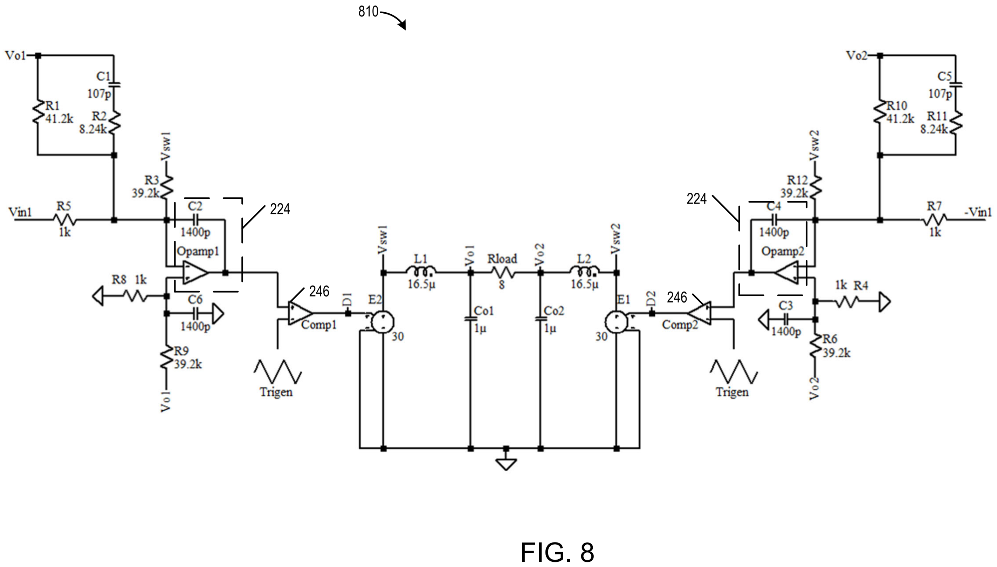

Figure 8 illustrates an example of a full-bridge implementation of the current controlled audio amplifier 510 of Figure 5B in accordance with certain embodiments. The audio amplifier 810 of Figure 5B combines two of the audio amplifier 510 to create the full bridge implementation. Combining two of the audio amplifier 510 to form the audio amplifier 810 results in double of each circuit element. For example, there are two integrators 224 each with its own operational amplifier or op amp. As another example, there are two comparators 246 within the audio amplifier 810. Each additional component can result in additional size, cost, and power requirements. It is generally desirable to reduce size, cost, and power requirements while maintaining the advantages of the full-bridge implementation of the audio amplifier.

Advantageously, embodiments disclosed herein enable the implementation of a full-bridge implementation of a current controlled audio amplifier without the doubling of the half-bridge amplifier. Moreover, embodiments disclosed herein enable the implementation of a full-bridge implementation of a current controlled audio amplifier using reduced components thereby reducing the size, cost, and, in some cases, power requirements compared to implementations that double the half-bridge amplifier to create the full-bridge amplifier. Embodiments disclosed herein can combine one or more current and voltage loops into a single op amp and comparator to provide the full bridge implementation of the current controlled audio amplifier. Thus, embodiments disclosed herein can reduce the number of op amps and comparators resulting in a smaller and less expensive audio amplifier.

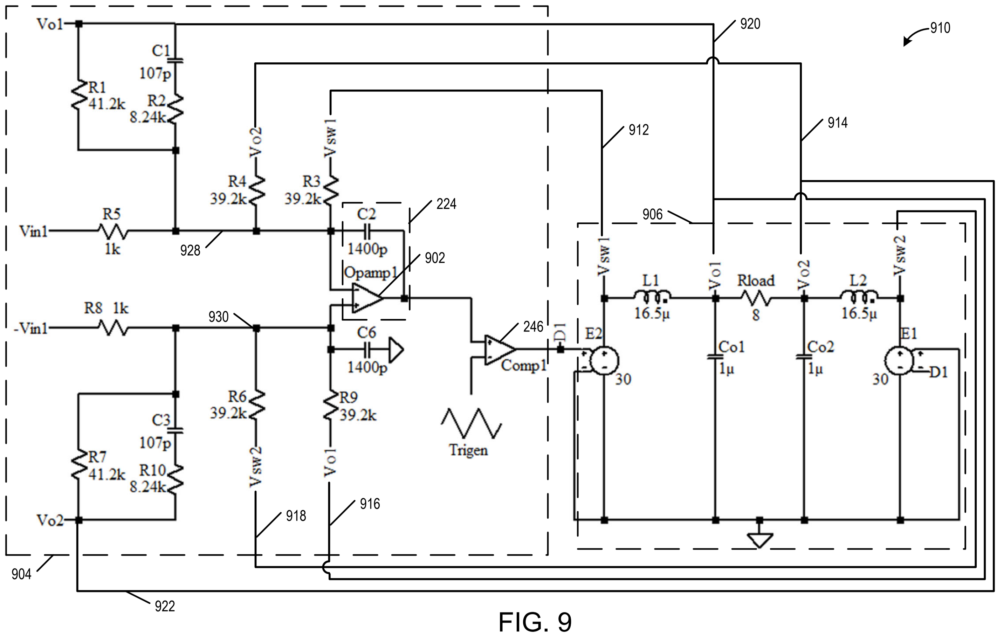

Figure 9 illustrates an example of a shared op amp implementation of the full bridge current controlled audio amplifier of Figure 8 in accordance with certain embodiments. The audio amplifier 910 can be divided into two stages, a control stage 904 and a power stage 906. It should be understood that the division of the audio amplifier 910 into stages may be a matter of convention and that the two stages may be combined into one stage or divided further.

The audio amplifier 910 of Figure 9 uses less operational amplifiers and comparators compared to the audio amplifier 810. As can be seen in Figure 9, the audio amplifier 910 includes one integrator 224 and only one op amp 902. Further, the audio amplifier 910 includes only a single comparator 246. Advantageously, the reduction in op amps and comparators using the shared op amp implementation compared to other designs that do not use the shared op amp results in a smaller and less expensive design. Moreover, the smaller design can, in some cases, reduce power consumption. For example, a smaller cooling system can be implemented in a smaller package enabling power usage reduction.

As explained with previous embodiments herein, it is possible to measure a current across the inductor L1 without using a separate sensor circuit. To sense the current of the inductor L1, a total current proportional to the voltage across the inductor L1 may be measured. This voltage may be given by (Vsw1-Vo1), wherein Vsw1 represents the switching voltage before the inductor L1 and Vo1 represents the output voltage after the inductor L1. A first current, Vsw1/R3, may be supplied to the integrator 224 through the resistor R3 through a feedback loop 912. A second current, -Vo1/R9, may be supplied to the integrator 224 through the resistor R9 through a feedback loop 916. The use of a differential integrator 224 can provide the '-' enabling the subtraction of Vo1/R9 from Vsw1/R3.

Similarly, it is possible to measure the current of the inductor L2 without using a separate sensor circuit. Moreover, it is possible to measure the current of the inductor L2 without using a separate integrator, thereby reducing the total number of op amps. To sense the current of the inductor L2, a total current proportional to the voltage across the inductor L2 may be measured. This voltage may be given by (Vsw2-Vo2), wherein Vsw2 represents the switching voltage before the inductor L2 and Vo2 represents the output voltage after the inductor L2. A first current, Vsw2/R6, may be supplied to the integrator 224 through the resistor R6 through a feedback loop 918. A second current, -Vo2/R4, may be supplied to the integrator 224 through the resistor R4 through a feedback loop 914.

In addition the feedback loops 912, 914, 916, and 918, the audio amplifier 910 may include a feedback loop 920 and a feedback loop 922. The feedback loop 920 feeds back the first output voltage, Vo1, from the output of the audio amplifier 910 to the summing node 928 via the RC circuit formed from the resistors R1, R2, and the capacitor C1. Similarly, the feedback loop 922 feeds back the second output voltage, Vo2, from the output of the audio amplifier 910 to the summing node 930 via the RC circuit formed from the resistors R7, R10, and the capacitor C3. As illustrated, the RC circuits of the feedback loop 920 and the feedback loop 922 may match or be the same. These additional feedback loops 920 and 922 may be part of the type II control system of the voltage or audio amplifier 910.

Further, the current model control of the audio amplifier 910 provides controls for a second order system without the use of a type 3 controller. The op amp 902 of the audio amplifier 910 can be driven differentially by the input signal Vin1 and -Vin1. By using the differential configuration, the common mode voltage of the one op amp 902 can be kept to a relatively smaller range (e.g., under 500 mV) enabling use of a simpler and less expensive op amp.

The output of the one op amp 902 of the integrator 224 is supplied to the comparator 246, which may receive a triangle wave signal from a triangle generator. The comparator 246 output may be supplied to a set of power FETs E1 and E2. The power FETs E1 and E2 may be implemented as the power output stage 306. The output, D1, of the comparator 246 may be supplied to the positive input of the power FETs E2. In contrast, the output, D1, of the comparator 246 may be inverted by supplying the output to the negative input of E1. Supplying the output D1 of the comparator 246 to the positive terminal of E2 may result in an input to E2 causing a positive voltage to be applied to the inductor L1. In contrast, supplying D1 to the negative input of E1 may result in a negative voltage being applied to the inductor L2. In this manner, a differential voltage is generated creating an output signal. In contrast, if the input were not inverted then there would be no resulting differential voltage and an output signal is not generated.

The audio amplifier 910 may be a fixed frequency design that includes a square wave clock (not shown). As with certain other embodiments described herein, the triangle wave generator can be eliminated by using the square wave clock and grounding the second input to the comparator 246. Advantageously, using the existing square wave clock enables the elimination of the triangle generator.

Each LC filter of the power stage 906 can receive a comparator output signal from the comparator 246. For example, the L1Col filter can receive the signal D1 supplied to the power FETs E2. Similarly, the L2Co2 filter can receive the signal -D1 supplied to the power FETs E1. The LC filters may each be connected to the output load resistor Rload.

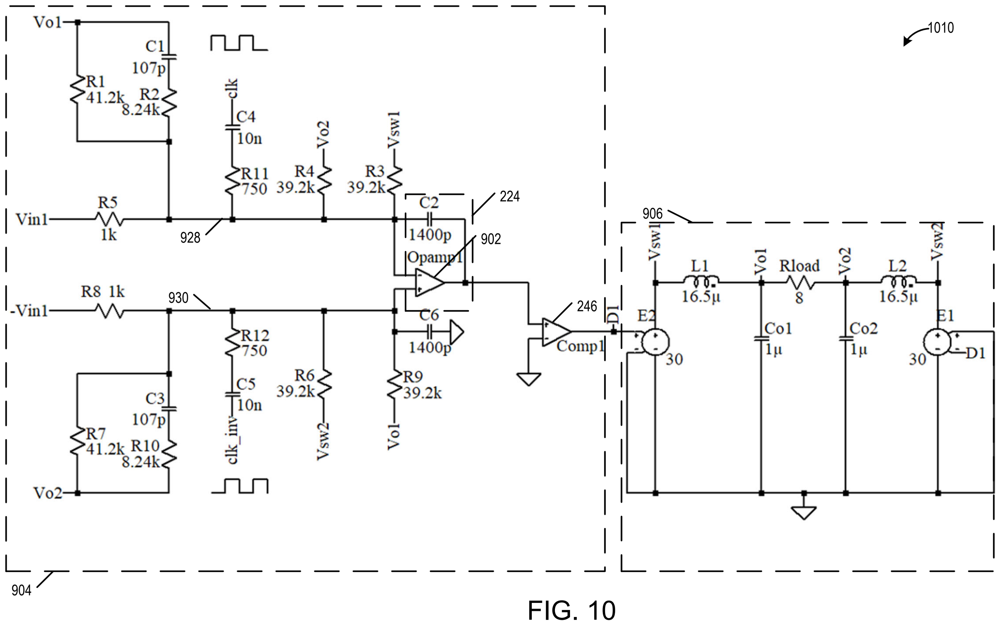

Figure 10 illustrates an example of the shared op amp implementation of the full bridge current controlled audio amplifier of Figure 9 using a square wave clock in accordance with certain embodiments. Although the lines are omitted to simplify the drawing, the audio amplifier 1010 of Figure 10 can include the same feedback loops as illustrated in Figure 9. As illustrated, the negative input of the comparator 246 is connected to ground in place of the triangle generator. Further, a square wave clock signal may be supplied at the summing node 928. Similarly, an inverted version of the square wave clock signal may be supplied at the summing node 930. The square wave clock and the integrated square wave clock signals are both provided before the integrator 224. Providing the square wave clock and the integrated square wave clock to the two inputs of the differential integrator maintains a balanced operation of the audio amplifier 1010. Further, the audio amplifier 1010 can include the embodiments and advantages associated with the audio amplifier 440 and/or the audio amplifier 530 for a full bridge current controlled audio amplifier.

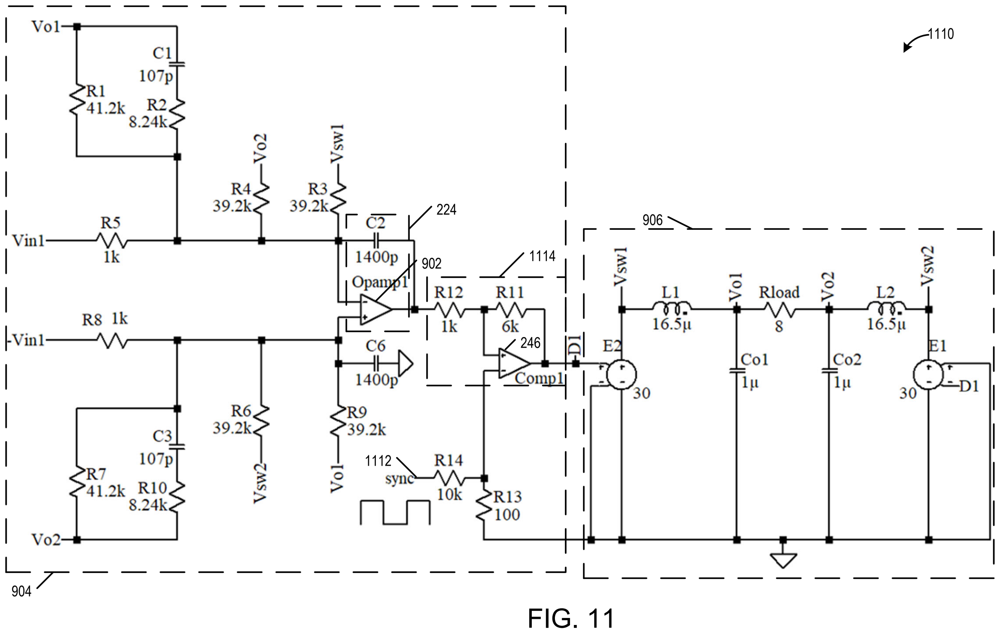

The audio amplifier 910 and audio amplifier 1010 may be fixed frequency amplifiers. For example, the fixed frequency amplifiers may operate between 125 and 400 kHz. However, as illustrated in Figure 11, it is also possible for the audio amplifier to operate using a variable frequency.

Figure 11 illustrates an example of a variable frequency current controlled audio amplifier with optional clock synchronization in accordance with certain embodiments. Although the lines are omitted to simplify the drawing, the audio amplifier 1110 of Figure 11 can include the same feedback loops as illustrated in Figure 9. Further, the audio amplifier 1110 can include a hysteretic modulator 1114. The hysteretic modulator 1114 can include the comparator 246 along with the resistors R11 and R12. Further, although illustrated outsides of the box representing the hysteretic modulator 1114, the hysteretic modulator 1114 may further include the resistor R13.

The hysteretic modulator 1114 may help regulate the output of the audio amplifier 1110 based on a previous output of the audio amplifier 1110 as well as the voltage of the current input signal.

Further, the audio amplifier 1110 can, optionally, electrically connect the square wave clock to the negative input of the comparator 246. Providing the square wave clock input to the comparator 246 enables the audio amplifier 1110 to operate with a variable frequency while synchronizing the output using the square wave clock input at the synchronization input 1112. Although in some embodiments it is unnecessary to synchronize the audio amplifier 1110 to an external clock, it can be advantageous when processing multiple audio channels. Synchronizing the multiple audio channels by supplying the square wave clock can help reduce or prevent beat frequencies in the audio band. In embodiments where a single channel amplifier is being used, the synchronization clock signal (e.g., the square wave clock supplied to the synchronization input 1112) can be omitted.

Example Half-Bridge Single Op Amp Design

As explained above, and with reference to Figure 3, to enable current mode control, it is desirable to determine the current flowing through the inductor L1. This current is described as (Vsw-Vout)/R3 and can be broken down into a current, Vsw/R3, and a current, -Vout/R3, which are supplied to the summing node 228. The Vsw/R3 current can be obtained via the feedback loop 308, which supplies the current to the summing node 228. The -Vout/R3 can be obtained via the second feedback loop 310, which supplies the current to the summing node 228. As explained above, the second feedback loop 310 includes an op amp U3 that enables the current Vout/R3 to be subtracted from the current Vsw/R3. However, it is desirable to reduce the number of op amps within the audio amplifier for the various reasons discussed herein.

Embodiments disclosed herein can eliminate the op amp U3 used to obtain the '-' for obtaining the current Vout/R3 by modifying the feedback loop 312 that connects the output voltage Vout to the summing node 228 through the resistor R1 and the RC circuit formed from the capacitor C1 and the resistor R2 of Figure 3. In certain embodiments, the op amp U3, and the resistors R5, R6, and R7 can all be eliminated from the audio amplifier 204 further reducing the size, complexity, and/or power consumption of the audio amplifier 204. The aforementioned circuit elements can be eliminated by subtracting the current that flows through the R7 via the feedback loop 310 from the current flowing through the feedback resistor R1 via the feedback loop 312. The current flowing through R1 can be modified by adjusting the value of the resistor R1 to obtain R1new using the following equations. Equation 2 below can be used to calculate the feedback current through R1.

$$I_{R1} = Vo * \frac{R6}{R5} * \frac{1}{R7} \qquad (2)$$

The new current through the resistor R1 can be calculated using equation (3) below where $R1_{new}$ represents the new resistor to be used in place of the resistor R1, termed $R1_{old}$ in the below equations, from the audio amplifier 204 of Figure 3.

$$\frac{Vo}{R1_{new}} = \frac{Vo}{R1_{old}} - Vo * \frac{R6}{R5} * \frac{1}{R7} \qquad (3)$$

Once the new current is calculated using equation (3), the resistance R1 that results in the desired current for an output voltage, Vo, can be calculated using equation (4) below where $R1_{new}$ replaces the original R1, or $R1_{old}$, of Figure 3.

$$R1_{new} = \left(\frac{1}{R1_{old}} - \frac{R6}{R5} * \frac{1}{R7}\right) \qquad (4)$$

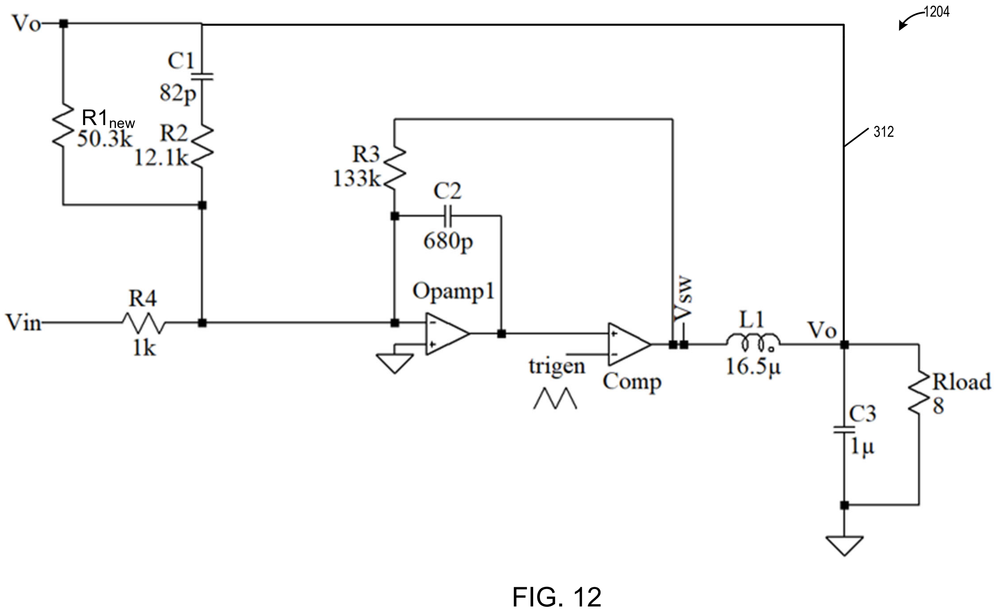

The new resistor, $R1_{new}$, may replace the resistor R1 of Figure 3. In Figure 3, the resistor R1 has the value of 36.5k ohms. Using the above equations, and the values illustrated in Figure 3, the new resistor $R1_{new}$ may be determined to be 50.3k ohms as illustrated in Figure 12

Figure 12 illustrates a circuit diagram of a reduced circuit audio amplifier in accordance with certain embodiments. The audio amplifier 1204 of Figure 12 includes the feedback loop 312 previously illustrated in Figure 3. As illustrated, the R1 of Figure 3 has been replaced with the $R1_{new}$ calculated using the equations above. Further, the use of $R1_{new}$ enables the elimination of the feedback loop 310 and the associated circuit elements including the second op amp U3 as well as the resistors R5, R6, and R7. Thus, the use of $R1_{new}$ enables a reduction in circuit elements, which enables a reduction in size of the audio amplifier 1204 compared to the audio amplifier 204.

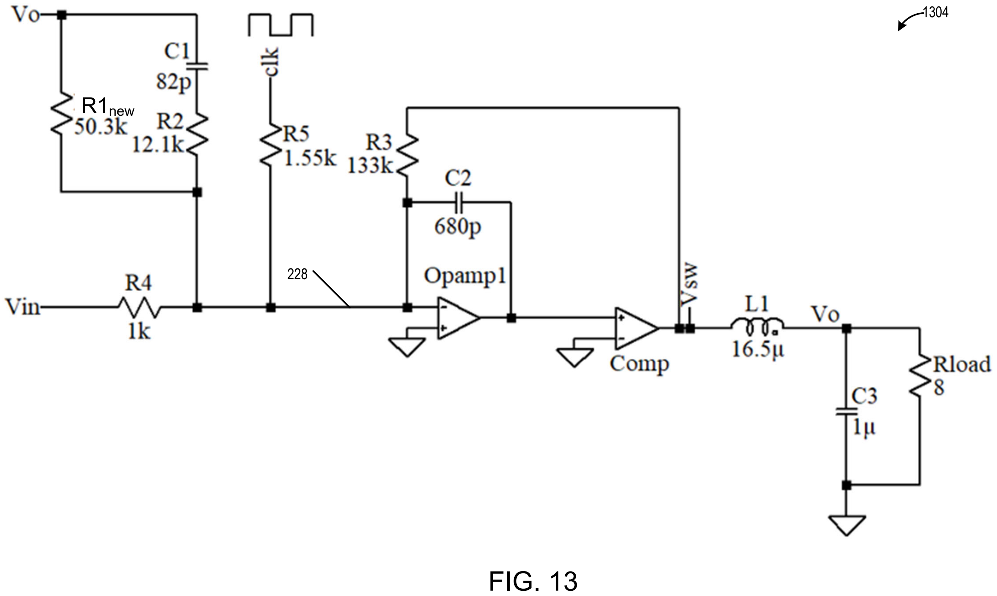

Figure 13 illustrates a circuit diagram of a reduced circuit audio amplifier of Figure 12 using a square wave clock in accordance with certain embodiments. The audio amplifier 1304 may be configured similarly to the audio amplifier 1204, including the elimination of feedback loop 310 and the replacement of R1 with $R1_{new}$. Further, similar to audio amplifier 204, the comparator of audio amplifier 1204 may receive an input from a triangle generator. In contrast, the comparator of audio amplifier 1304 may connect the comparator to ground instead of the triangle generator, and a square wave clock input may be received instead at the summing node 228 through the resistor R5.

A number of different audio amplifier designs have been described herein and illustrated in the drawings. It should be understood that each of the audio amplifiers herein may include one or more of the embodiments described with respect to another audio amplifier described herein. For example, although not illustrated, it should be understood that the half bridge amplifier 1204 of Figure 12 can be converted into a full bridge amplifier as described with respect to the audio amplifier 910 of Figure 9.

Terminology

It is to be understood that not necessarily all objects or advantages may be achieved in accordance with any particular aspect or embodiment described herein. Thus, for example, those skilled in the art will recognize that certain aspects or embodiments may be configured to operate in a manner that achieves or optimizes one advantage or group of advantages as taught herein without necessarily achieving other objects or advantages as may be taught or suggested herein.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." The term "coupled" is used to refer to the connection between two elements, the term refers to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the above Detailed Description using the singular or plural number may also include the plural or singular number respectively. The word "or" in reference to a list of two or more items, that word covers all of the following interpretations of the word: any of the items in the list, all of the items in the list, and any combination of the items in the list.

The above detailed description of aspects or embodiments of the inventions are not intended to be exhaustive or to limit the inventions to the precise form disclosed above. While specific aspects and embodiments of, and examples for, the inventions are described above for illustrative purposes, various equivalent modifications are possible within the scope of the inventions, as those skilled in the relevant art will recognize. For example, while processes or blocks are presented in a given order, alternative aspects or embodiments may perform routines having steps, or employ systems having blocks, in a different order, and some processes or blocks may be deleted, moved, added, subdivided, combined, and/or modified. Each of these processes or blocks may be implemented in a variety of different ways. Also, while processes or blocks are at times shown as being performed in series, these processes or blocks may instead be performed in parallel, or may be performed at different times.

The teachings of the inventions provided herein can be applied to other systems, not necessarily the system described above. The elements and acts of the various aspects and embodiments described above can be combined to provide further aspects and embodiments.

Conditional language used herein, such as, among others, "can," "might," "may," "e.g.," and the like, unless specifically stated otherwise, or otherwise understood within the context as used, is generally intended to convey that certain aspects or embodiments include, while other aspects or embodiments do not include, certain features, elements and/or states. Thus, such conditional language is not generally intended to imply that features, elements and/or states are in any way required for one or more embodiments or that one or more embodiments necessarily include logic for deciding, with or without author input or prompting, whether these features, elements and/or states are included or are to be performed in any particular embodiment.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B and C" can include a first processor configured to carry out recitation A working in conjunction with a second processor configured to carry out recitations B and C.

While certain aspects or embodiments of the inventions have been described, these aspects or embodiments have been presented by way of example only, and are not intended to limit the scope of the disclosure. Indeed, the novel methods and systems described herein may be embodied in a variety of other forms; furthermore, various omissions, substitutions and changes in the form of the methods and systems described herein may be made without departing from the spirit of the disclosure. The accompanying claims and their equivalents are intended to cover such forms or modifications as would fall within the scope and spirit of the disclosure.

**Claims**

1. An audio amplifier comprising:

a power output stage comprising a first LC filter and a second LC filter, the first LC filter configured to receive a comparator output signal from a comparator corresponding to an audio output signal and the second LC filter configured to receive an inverted comparator output signal from the comparator; and
a control stage comprising:

a first feedback loop between a first node and a first summing node, the first node between the comparator and a first inductor of the first LC filter, wherein the first feedback loop is configured to provide a first current to an inverting input of an integrator at the first summing node;
a second feedback loop between a second node and a second summing node, the second node between the first inductor and an output load resistor of the audio amplifier, wherein the second feedback loop is configured to provide a second current to a noninverting input of the integrator at the second summing node;
a third feedback loop between a third node and the second summing node, the third node between the comparator and a second inductor of the second LC filter, wherein the third feedback loop is configured to provide a third current to the noninverting input of the integrator at the second summing node; and
a fourth feedback loop between a fourth node and the first summing node, the fourth node between the second inductor and the output load resistor of the audio amplifier, wherein the fourth feedback loop is configured to provide a fourth current to the inverting input of the integrator at the first summing node, and wherein an integrator output of the integrator provides current mode control of the audio amplifier.

2. The audio amplifier of claim 1, wherein the first node is between an output stage, E2, and the first inductor, and wherein a first power transistor receives an output of the comparator at a positive terminal of the output stage, E2.

3. The audio amplifier of claim 1 or claim 2, wherein the integrator comprises an operational amplifier configured to receive an input signal at the inverting input and an inverted input signal at the noninverting input.

4. The audio amplifier as in any one of claims 1-3, wherein the comparator receives a triangle wave at a negative input to the comparator and an output of the integrator at a positive input to the comparator.

5. The audio amplifier as in any one of claims 1-4, wherein the audio amplifier implements a full bridge operation using a single operational amplifier.

6. The audio amplifier as in any one of claims 1-5, further comprising a fifth feedback loop between the second node and the first summing node, wherein the fifth feedback loop includes a first RC circuit.

7. The audio amplifier of claim 6, further comprising a sixth feedback loop between the fourth node and the second summing node, wherein the sixth feedback loop includes a second RC circuit.

8. The audio amplifier of claim 7, wherein the first RC circuit is configured to match the second RC circuit.

9. The audio amplifier as in any one of claims 1-8, wherein a voltage at the second node comprises a first output voltage and a voltage at the fourth node comprises a second output voltage.

10. The audio amplifier of claim 1, further comprising a first square wave clock input to the first summing node, wherein a negative input of the comparator is connected to ground, and wherein a combination of the first square wave clock and the grounded comparator enables elimination of a triangle generator.

11. The audio amplifier of claim 10, further comprising a second square wave clock input to the second summing node, wherein the second square wave clock input receives an inverted square wave clock signal relative to a square wave clock signal received at the first square wave clock input.

12. The audio amplifier as in any one of claims 1-11, wherein the integrator output of the integrator provides current mode control of the audio amplifier without inclusion of a current sensor.

13. The audio amplifier as in any one of claims 1-12, wherein the first feedback loop comprises a first resistor configured to provide the first current to the inverting input of the integrator, wherein the second feedback loop comprises a second resistor configured to provide the second current to the noninverting input of the integrator at the second summing node, and wherein the first resistor and the second resistor have the same resistance.

14. The audio amplifier of claim 1, further comprising a synchronization square wave clock connected to a negative input of the comparator.

15. An audio system comprising:

a speaker configured to output audio; and
an audio amplifier as in any one of claims 1-14 in communication with the speaker and configured to provide an audio output signal to the speaker for output.

FIG. 1A

FIG. 1B

EP 4 730 650 A1

FIG. 2A

FIG. 2B

EP 4 730 650 A1

FIG. 2C

EP 4 730 650 A1

FIG. 2D

FIG. 2E

Rload 8

Vo

C1 1μ

L1 16.5μ

Vsw

Comp

246

Trigen

248

244

R4 412k

Vo

242

R3 10k

Opamp2

Cint 1400p

R2 952

Opamp1

224

Vsw

R1 39.2k

228

Vo

Cp 107p

Rp 8.24k

Rf 41.2k

Rin 1k

Vin

250

FIG. 3

FIG. 4A

FIG. 4B

FIG. 4C

FIG. 4D

FIG. 4E

FIG. 5A

FIG. 5B

FIG. 5C

FIG. 5D

EP 4 730 650 A1

FIG. 6

FIG. 7

FIG. 8

EP 4 730 650 A1

FIG. 9

FIG. 10

FIG. 11

FIG. 12

EP 4 730 650 A1

FIG. 13

Europäisches Patentamt

European Patent Office

Office européen des brevets

**EUROPEAN SEARCH REPORT**

Application Number

EP 25 20 9878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 961 921 A1 (RGB SYSTEMS INC [US]) 2 March 2022 (2022-03-02) * figures 1-7 * * paragraphs [0001] - [0067] * ----- | 1-15 | INV. H03F3/183 H03F3/217 H03F3/45 |

TECHNICAL FIELDS SEARCHED (IPC)

H03F

The present search report has been drawn up for all claims

| Place of search | Date of completion of the search | Examiner |
|---|---|---|
| The Hague | 11 February 2026 | Jespers, Michaël |

EPO FORM 1503 03.82 (P04C01)

## ANNEX TO THE EUROPEAN SEARCH REPORT
## ON EUROPEAN PATENT APPLICATION NO.

EP 25 20 9878

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2026

| Patent document cited in search report | Publication date | Patent family member(s) | Publication date |
|---|---|---|---|
| EP 3961921 A1 | 02-03-2022 | EP 3961921 A1<br>US 2022069783 A1 | 02-03-2022<br>03-03-2022 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63709876